(19) **Europäisches Patentamt / European Patent Office / Office européen des brevets**

(11) **EP 3 151 266 B1**

(12) # FASCICULE DE BREVET EUROPEEN

(45) Date de publication et mention
de la délivrance du brevet:
**22.11.2017 Bulletin 2017/47**

(51) Int Cl.:
***H01L 21/20*** *(2006.01)* ***H01L 21/02*** *(2006.01)*

(21) Numéro de dépôt: **16190980.9**

(22) Date de dépôt: **28.09.2016**

(54) **PROCEDE DE FORMATION D'UNE PORTION SEMICONDUCTRICE PAR CROISSANCE EPITAXIALE SUR UNE PORTION CONTRAINTE**

VERFAHREN ZUR ERSTELLUNG EINES HALBLEITERABSCHNITTS DURCH EPITAXISCHES WACHSTUM AUF EINEM VERSPANNTEN ABSCHNITT

METHOD FOR FORMING A SEMICONDUCTOR PORTION BY EPITAXIAL GROWTH ON A STRESSED PORTION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **30.09.2015 FR 1559284**

(43) Date de publication de la demande:
**05.04.2017 Bulletin 2017/14**

(73) Titulaire: **Commissariat à l'énergie atomique et aux énergies alternatives**
**75015 Paris (FR)**

(72) Inventeurs:
• **REBOUD, Vincent**
**75013 PARIS (FR)**
• **GASSENQ, Alban**
**30560 SAINT-HILAIRE (FR)**
• **GUILLOY, Kévin**
**38000 GRENOBLE (FR)**
• **CALVO, Vincent**
**38600 FONTAINE (FR)**
• **TCHELNOKOV, Alexei**
**38240 MEYLAN (FR)**

(74) Mandataire: **GIE Innovation Competence Group**
**310, avenue Berthelot**
**69372 Lyon Cedex 08 (FR)**

(56) Documents cités:
• **DAMLENCOURT J F ET AL: "High-quality fully relaxed In0.65Ga0.35As layers grown on InP using the paramorphic approach", APPLIED PHYSICS LETTERS, AMERICAN INSTITUTE OF PHYSICS, 2 HUNTINGTON QUADRANGLE, MELVILLE, NY 11747, vol. 75, no. 23, 6 décembre 1999 (1999-12-06), pages 3638-3640, XP012024201, ISSN: 0003-6951, DOI: 10.1063/1.125413**
• **BOUDAA M ET AL: "Growth and characterization of totally relaxed InGaAs thick layers on strain-relaxed paramorphic InP substrates", JOURNAL OF ELECTRONIC MATERIALS TMS; IEEE USA, vol. 33, no. 7, juillet 2004 (2004-07), pages 833-839, XP002754610, ISSN: 0361-5235**
• **COHEN G ET AL: "Dislocation-free strained silicon-on-silicon by in-place bonding", APPLIED PHYSICS LETTERS, AMERICAN INSTITUTE OF PHYSICS, 2 HUNTINGTON QUADRANGLE, MELVILLE, NY 11747, vol. 86, no. 25, 13 juin 2005 (2005-06-13) , pages 251902-251902, XP012065917, ISSN: 0003-6951, DOI: 10.1063/1.1949284**

**Description**

**DOMAINE TECHNIQUE**

Le domaine de l'invention est celui de la croissance épitaxiale d'une portion semiconductrice sur une portion contrainte de germination reposant sur une couche support. L'invention s'applique en particulier à la réalisation d'un dispositif microélectronique ou optoélectronique comportant une telle portion semiconductrice dont la structure cristallographique présente avantageusement pas ou peu de défauts structuraux.

**ÉTAT DE LA TECHNIQUE ANTÉRIEURE**

Dans diverses applications microélectroniques ou optoélectroniques, il peut être avantageux d'utiliser une couche semiconductrice en un matériau cristallin contraint. C'est le cas notamment des transistors haute performance où la contrainte subie par le matériau peut se traduire par une augmentation de la vitesse de déplacement des porteurs de charge, améliorant ainsi les performances du transistor. C'est le cas également de certaines sources de lumière dont le matériau de la couche émissive ou du milieu à gain présente, hors contrainte, une structure de bandes d'énergie indirecte, la structure de bandes étant alors rendue sensiblement directe par l'application d'une contrainte adéquate.

Il peut également être avantageux de former une couche ou une portion de couche semiconductrice par croissance épitaxiale sur une telle couche contrainte, cette dernière étant alors adaptée à la croissance de la couche à épitaxier. Se pose alors d'une manière générale la difficulté d'un éventuel désaccord de maille entre la couche de germination / support et la couche épitaxiale, qui peut se traduire le cas échéant par l'apparition de défauts structuraux à l'interface entre les couches, défauts susceptibles de dégrader les propriétés électroniques et/ou optiques de la couche épitaxiée. Le désaccord de maille s'entend comme la différence relative entre le paramètre de maille $a_c$ du matériau à épitaxier et celui $a_g$ de la couche de germination, et peut s'exprimer par le paramètre $\Delta a/a = (a_c-a_g)/a_c$. La couche épitaxiale croît avec un paramètre de maille sensiblement égal à celui de la couche de germination mais subit une déformation de sa structure cristallographique qui se traduit par la génération de contraintes mécaniques, notamment en compression ou en tension. A partir d'une épaisseur dite critique, les contraintes subies par la couche épitaxiale peuvent relaxer et provoquer l'apparition de défauts structuraux, par exemple des dislocations dites de désaccord de maille, localisés à l'interface avec la couche de germination, entraînant alors une dégradation des propriétés électroniques et/ou optiques de la couche épitaxiée.

Aussi, la croissance épitaxiale d'une couche semiconductrice sur une couche contrainte de germination peut permettre de modifier voire contrôler le désaccord de maille. Le document WO03/045837 décrit un exemple de procédé de formation d'une portion semiconductrice par épitaxie sur une portion contrainte de germination. On réalise tout d'abord un empilement d'une couche de germination, par exemple en silicium, solidaire d'une couche support par l'intermédiaire d'une couche sacrificielle intercalée. La couche de germination est structurée de manière à former une portion de germination reliée à une partie périphérique. La portion de germination est ensuite suspendue au-dessus d'une cavité formée par gravure de la couche sacrificielle sous-jacente, puis est mise sous contrainte par le dépôt d'un matériau adapté de part et d'autre de la portion de germination. Une portion semiconductrice, par exemple en silicium germanium ou en matériaux III-V est ensuite formée par épitaxie à partir de la portion contrainte de germination. On peut ainsi, par exemple, modifier la composition dans la portion épitaxiée de silicium germanium en fonction de la contrainte subie par la portion de germination.

Il existe cependant un besoin pour obtenir une structure semiconductrice comportant une portion semiconductrice épitaxiée sur une portion contrainte de germination, qui puisse supporter des étapes ultérieures classiques de microélectronique, telles que des étapes de dépôt de couche, de lithographie et de gravure, voire de dopage, en fonction des applications microélectroniques ou optoélectroniques visées. Dans les articles DAMLENCOURT J F ET AL: "High-quality fully relaxed In0.65Ga0.35As layers grown on InP using the paramorphic approach", APPLIED PHYSICS LETTERS, AMERICAN INSTITUTE OF PHYSICS, 2 HUNTINGTON QUADRANGLE, MELVILLE, NY 11747, vol. 75, no. 23, 6 décembre 1999 (1999-12-06), pages 3638-3640, XP012024201, et BOUDAA M ET AL: "Growth and characterization of totally relaxed InGaAs thick layers on strain-relaxed paramorphic InP substrates",JOURNAL OF ELECTRONIC MATERIALS TMS; IEEE USA, vol. 33, no. 7, juillet 2004 (2004-07), pages 833-839, XP002754610,ISSN: 0361-5235, une couche sacrificielle est crûe sur un substrat, suivie d'une couche contrainte en tension avec une épaisseur inférieure à l'épaisseur critique de sorte qu'aucun défaut ne se forme. L'empilement initial est structuré en une zone centrale reliée à la zone périphérique par deux bras. Après sous-gravure pour enlever la couche sacrificielle, une membrane relaxée est formée, suspendue par les deux bras. Après séchage, la membrane se colle sur le support par adhésion moléculaire. La croissance épitaxiale est ensuite réalisée sur toute la membrane.

COHEN G ET AL: "Dislocation-free strained silicon-on-silicon by in-place bonding",APPLIED PHYSICS LETTERS, AMERICAN INSTITUTE OF PHYSICS, 2 HUNTINGTON QUADRANGLE, MELVILLE, NY 11747, vol. 86, no. 25, 13 juin 2005 (2005-06-13), pages 251902-1 to 251902-3, XP012065917,ISSN: 0003-6951, DOI: 10.1063/1.1949284 décrit la croissance pseudomorphique de SiGe sur SOI, suivie par l'épitaxie d'une couche mince de Si pour obtenir un empilement symétrique Si / SiGe / Si avec une contrainte de compression dans la couche de SiGe centrale. La couche d'oxyde de SOI est sous-gravée, et la structure se relaxe de sorte qu'une partie de la contrainte de compression de la couche de SiGe centrale est transférée vers les couches extérieures de Si en les mettant en tension. A cause de forces d'adhérence au substrat, la couche inférieure reste en tension même après l'enlèvement des couches supérieures de SiGe et Si.

## EXPOSÉ DE L'INVENTION

L'invention a pour objectif de remédier au moins en partie aux inconvénients de l'art antérieur, et plus particulièrement de proposer un procédé de formation d'une portion semiconductrice par croissance épitaxiale sur une portion contrainte de germination. Pour cela, l'objet de l'invention est un procédé de formation d'une portion semiconductrice par croissance épitaxiale sur une portion contrainte de germination, comportant les étapes dans lesquelles :

i) on fournit un empilement formé d'une couche de germination recouvrant une couche sacrificielle disposée sur une couche support, ladite couche de germination présentant une valeur initiale non nulle de contrainte en tension ;
ii) on structure la couche de germination de manière à former une partie structurée et une partie périphérique, la partie structurée comportant une portion centrale reliée à la partie périphérique par au moins deux portions latérales opposées l'une à l'autre vis-à-vis de la portion centrale, les portions latérales présentant une largeur moyenne supérieure à une largeur moyenne de la portion centrale ;
iii) on réalise une cavité sous la partie structurée en rendant libre une surface de la couche support située en regard de la partie structurée, la portion centrale, dite portion contrainte de germination, étant alors contrainte ;
iv) on forme la portion semiconductrice par croissance épitaxiale sur la portion contrainte de germination en tension à une valeur finale supérieure à la valeur initiale ;

dans lequel, lors de l'étape iii), on réalise en outre une mise en contact de la partie structurée avec ladite surface libre de manière à rendre solidaire la partie structurée de ladite surface libre.

Certains aspects préférés mais non limitatifs de ce procédé de réalisation sont les suivants :

Lors de l'étape ii), la portion de germination peut être contrainte de sorte que, lors de l'étape iv), la portion semiconductrice est épitaxiée de manière sensiblement relaxée.

Lors de l'étape ii), la portion centrale peut être reliée à la partie périphérique par au moins deux portions latérales opposées l'une à l'autre vis-à-vis de la portion centrale, de sorte que, lors de l'étape iii), la portion centrale est contrainte par les portions latérales.

Le procédé peut comporter en outre les étapes suivantes :

- préalablement à l'étape i) de fourniture de l'empilement, estimation d'une valeur finale de contrainte en tension pour laquelle la couche de germination présente un paramètre de maille sensiblement égal au paramètre de maille dit naturel de la portion semiconductrice ;
- détermination de la structuration de sorte que, après l'étape iii) de réalisation de la cavité, la portion contrainte de germination présente ladite valeur finale de contrainte en tension, et donc un paramètre de maille sensiblement égal au paramètre de maille naturel de la portion semiconductrice, de sorte que, lors de l'étape iv), la portion semiconductrice est épitaxiée de manière sensiblement relaxée.

Lors de l'étape de détermination, la largeur moyenne des portions latérales et la largeur moyenne de la portion centrale peuvent être choisies de sorte que la portion centrale présente, lors de l'étape de réalisation de la cavité, ladite valeur finale de contrainte en tension.

La portion semiconductrice peut présenter un paramètre de maille naturel supérieur au paramètre de maille naturel de la couche de germination. Le paramètre de maille des couches et portions est mesuré dans un plan de la couche ou de la portion considérée parallèle au plan de la couche support.

L'étape iv) peut comporter une sous-étape préalable dans laquelle on dépose un masque de croissance sur la partie structurée de manière à recouvrir les portions latérales et à rendre libre une surface de la portion centrale de germination, dite surface de germination, la portion semiconductrice étant formée à partir de la surface de germination.

A la suite de l'étape iii), la partie structurée peut être solidaire de la surface libre de la couche support par collage moléculaire, et on peut effectuer les sous-étapes suivantes :

a) on détermine une valeur minimale d'énergie de collage moléculaire de la partie structurée sur la couche support, ainsi qu'une valeur minimale de surface collée des portions latérales sur la couche support, ces valeurs minimales étant telles que ladite énergie de collage moléculaire est supérieure à une énergie élastique de la partie structurée ;
b) on effectue, après l'étape iii) ou iv), un recuit de consolidation à une température de recuit telle que l'énergie de collage moléculaire présente une valeur supérieure ou égale à ladite valeur minimale préalablement déterminée ; puis
c) on grave une partie distale des portions latérales vis-à-vis de la portion contrainte de germination, de sorte que la surface collée des portions latérales présente une valeur supérieure ou égale à ladite valeur minimale préalablement déterminée.

On peut réaliser l'étape c) de gravure après l'étape iv) de croissance épitaxiale au cours de laquelle on effectue l'étape b) de recuit de consolidation.

Lors de l'étape c), on peut graver une partie distale des portions latérales formant raccord avec la partie périphérique de la couche de germination.

A la suite de l'étape c), la partie structurée peut présenter une face supérieure opposée à la couche support sensiblement plane.

Lors de l'étape iii), on peut réaliser la cavité et la mise en contact par gravure par HF en phase vapeur éventuellement suivie par le dépôt puis l'évaporation d'un liquide au niveau de la cavité, et lors de l'étape b) la température de recuit peut être sensiblement supérieure ou égale à 200°C.

Lors de l'étape iii), on peut réaliser une oxydation ou une nitruration de ladite surface libre et d'une surface de la partie structurée orientée vers la surface libre, et lors de l'étape b) la température de recuit peut être sensiblement supérieure ou égale à 100°C.

A la suite de l'étape iii), une couche diélectrique, issue de ladite oxydation ou nitruration réalisée, peut être formée à l'interface entre la partie structurée et la couche support, qui présente une épaisseur de préférence supérieure ou égale à 10nm.

Lors de l'étape ii), la structuration des portions latérales peut être réalisée de sorte que, lors de l'étape iii), la portion contrainte de germination présente une déformation uniaxiale ou biaxiale.

La portion semiconductrice épitaxiée peut comporter au moins une partie dopée avec un niveau de dopage supérieur ou égal à $2.10^{18}$ cm$^{-3}$.

L'invention porte également sur un procédé de réalisation d'un dispositif optoélectronique comportant une portion semiconductrice obtenue par le procédé selon l'une quelconque des caractéristiques précédentes, dans lequel on réalise une jonction PN ou PIN dans la portion semiconductrice, la jonction s'étendant de manière sensiblement orthogonale ou parallèle au plan de la couche support.

On peut réaliser une cavité optique dans laquelle est située la portion semiconductrice dont le matériau est adapté à former un milieu à gain, le dispositif obtenue étant adapté à émettre un faisceau lumineux cohérent.

L'invention porte également sur une structure semiconductrice comportant une portion semiconductrice épitaxiée sur une portion contrainte de germination solidaire par adhérence moléculaire d'une couche support.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

les figures 1a à 1e illustrent, de manière schématique et en vue en coupe, différentes étapes d'un procédé de formation d'une portion semiconductrice par croissance épitaxiale sur une portion contrainte de germination, solidaire d'une couche support par collage moléculaire hydrophobe ;

la figure 2a illustre de manière schématique et en vue de dessus une portion semiconductrice épitaxiée sur une portion contrainte de germination subissant une déformation biaxiale, et la figure 2b illustre la partie structurée séparée d'une partie périphérique de la couche de germination ;

la figure 3a illustre de manière schématique et en vue de dessus une portion semiconductrice épitaxiée sur une portion contrainte de germination subissant une déformation uniaxiale, et la figure 3b illustre la partie structurée séparée d'une partie périphérique de la couche de germination ;

la figure 4 illustre un exemple de relation entre l'énergie surfacique de collage hydrophile et hydrophobe entre la partie structurée et la couche support en fonction d'une température de recuit de consolidation du collage moléculaire ;

les figures 5a à 5e illustrent, de manière schématique et en vue en coupe, différentes étapes d'un procédé de formation d'une portion semiconductrice par croissance épitaxiale sur une portion contrainte de germination, solidaire d'une couche support par collage moléculaire hydrophile ;

les figures 6a et 6b illustrent de manière schématique et en vue en coupe deux exemples de dispositif optoélectronique comportant une portion semiconductrice épitaxiée sur une portion contrainte de germination, le dispositif optoélectronique étant ici une diode électroluminescente comportant une jonction PIN orientée de manière verticale (figure 6a) ou horizontale (figure 6b) ;

les figures 7a à 7f illustrent de manière schématique et en vue en coupe différentes étapes d'un procédé de réalisation d'un dispositif optoélectronique comportant une portion semiconductrice épitaxiée sur une portion contrainte de germination, le dispositif optoélectronique étant ici une source laser dont la cavité optique est réalisée au niveau de la couche support ;

la figure 8 est un organigramme d'un procédé selon un mode de réalisation permettant d'obtenir une portion centrale d'une couche de germination dont le paramètre de maille est sensiblement au paramètre de maille naturel de la portion semiconductrice à épitaxier.

## EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près.

L'invention concerne d'une manière générale un procédé de formation d'une portion semiconductrice par croissance épitaxiale sur une portion contrainte de germination, celle-ci reposant sur une couche support.

Par portion, on entend une structure dont les dimensions dans un plan orthogonal à sa direction d'épaisseur sont inférieures à celles de la couche support sur laquelle elle repose. Une portion contrainte est une portion dont la structure cristallographique est contrainte, ici en tension ou en compression, déformant la maille cristalline dans un plan parallèle à l'interface entre les portions. La couche est contrainte en tension lorsqu'elle subit une contrainte mécanique qui tend à étirer les mailles du réseau cristallin dans le plan de la couche. Cela se traduit par la présence d'une contrainte en compression des mailles du réseau orientée suivant un axe sensiblement orthogonal au plan d'étirement, c'est-à-dire au plan de la couche. La portion est au contraire dite relaxée lorsque sa structure cristallographique est non contrainte, c'est-à-dire lorsque son paramètre de maille est identique au paramètre de maille naturel du matériau. Le paramètre de maille considéré ici est celui orienté dans un plan parallèle à l'interface entre la portion semiconductrice épitaxiée et la portion contrainte de germination. Par portion de germination, on entend une portion réalisée en un matériau favorisant la croissance de la portion semiconductrice.

On décrit par la suite un mode de réalisation préféré d'un procédé de réalisation d'une structure semiconductrice, comportant une portion de germanium monocristallin contraint, collée par adhérence moléculaire à une couche support de silicium, sur laquelle est épitaxiée en accord de maille une portion semiconductrice de $Ge_{1-x}Sn_x$ monocristallin. La portion semiconductrice est épitaxiée de sorte que sa structure cristallographique est sensiblement relaxée, son paramètre de maille étant alors sensiblement identique à son paramètre de maille naturelle. De manière alternative, une déformation de la portion épitaxiée peut être générée, l'épaisseur de la portion épitaxiée étant alors inférieure à l'épaisseur critique dont la valeur dépend notamment de la proportion atomique des éléments dans le composé GeSn. La déformation peut être mesurée directement par diffraction X ou TEM, ou indirectement par spectroscopie Raman.

D'une manière générale, le matériau de la portion semiconductrice épitaxiée est cristallin, de préférence monocristallin, et peut être choisi notamment parmi les éléments de la colonne IV de la classification périodique, tels que le silicium, le germanium, l'étain dans sa phase semiconductrice, et les alliages formés de ces éléments, par exemple le SiGe, le GeSn, le SiGeSn. Il peut également être choisi parmi les alliages comportant des éléments des colonnes III et V de la classification périodique, par exemple le GaInAs et l'InP, voire comportant des éléments des colonnes II et VI, par exemple le CdHgTe. Par ailleurs, le matériau de la couche de germination est adapté à favoriser la croissance de la portion semiconductrice à épitaxier, et peut comporter des éléments de la colonne IV de la classification périodique, voire des colonnes III et V. Le matériau de la couche support peut être choisi parmi le silicium, le saphir, le borosilicate, la silice, le verre, le quartz ou tout autre matériau adapté à être collé par adhérence moléculaire au matériau de la couche de germination. Enfin, le matériau de la couche sacrificielle peut être choisi parmi le silicium, un oxyde ou un nitrure, par exemple de silicium.

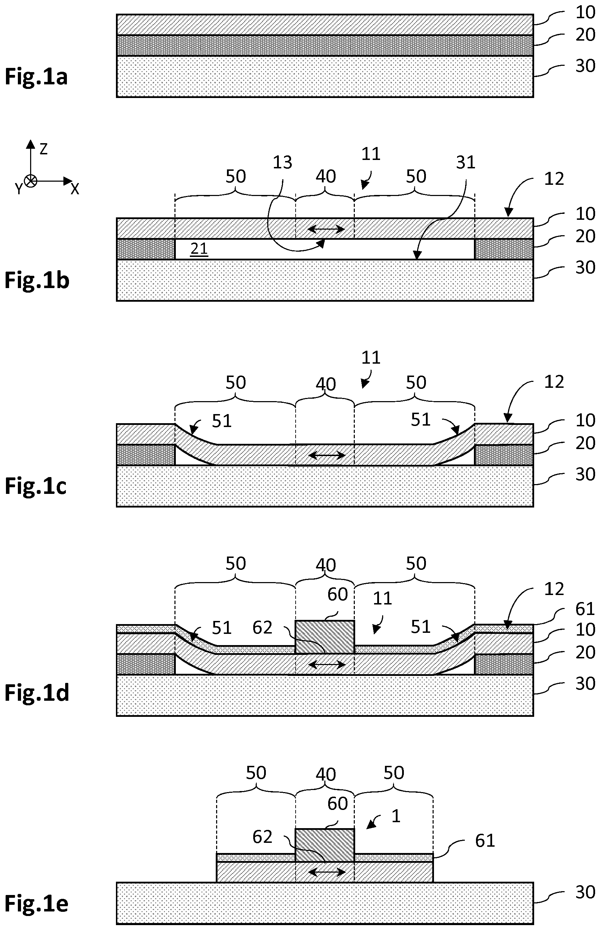

Les figures 1a à 1e illustrent des étapes d'un procédé de formation d'une portion semiconductrice épitaxiée sur une portion contrainte de germination, celle-ci reposant sur une couche support, selon un premier mode de réalisation. Dans cet exemple, la portion épitaxiée est réalisée en germanium-étain, la portion de germination est en germanium contraint en tension et la couche support est en silicium.

On définit ici un repère orthonormé (X,Y,Z) où X et Y sont les axes horizontaux définissant un plan parallèle aux plans suivant lesquels s'étendent les différentes couches et portions, et où Z est l'axe vertical suivant lequel l'épaisseur des couches et portions est définie. Les termes « haut / bas », « inférieur / supérieur » sont définis suivant l'axe vertical Z.

Selon une première étape illustrée sur la figure 1a, on réalise un empilement formé d'une couche de germination 10 solidarisée à une couche support 30 par l'intermédiaire d'une couche sacrificielle 20.

On réalise ici l'empilement sous forme d'un substrat GOI (pour *Germanium On Isulator,* en anglais), c'est-à-dire d'une couche de germination 10 de germanium recouvrant une couche sacrificielle 20 d'oxyde de silicium reposant ici sur une couche support 30 de silicium. Cet empilement est de préférence réalisé au moyen du procédé décrit dans la publication de Reboud et al. intitulée Structural and optical properties of 200 mm germanium-on-insulator (GeOI) substrates for silicon photonics applications, Proc. SPIE 9367, Silicon Photonics X, 936714 (February 27, 2015) qui met notamment en oeuvre la technologie Smart Cut™.

Plus précisément, on effectue tout d'abord la croissance épitaxiale d'une couche semiconductrice de germanium sur une couche épaisse de silicium. La couche de germanium présente alors, à température ambiante, une déformation résiduelle en tension de l'ordre de 0,2%. On dépose ensuite une couche diélectrique, par exemple un oxyde de silicium, sur la surface libre de la couche de germanium, puis on effectue une implantation d'ions H$^+$ dans la couche de germanium. Ensuite, on solidarise la couche diélectrique recouvrant la couche de germanium avec un substrat poignée formé d'une couche diélectrique recouvrant une couche de silicium. On sépare la couche de germanium en deux parties au niveau d'une zone fragilisée par l'implantation d'ions. On obtient ainsi une couche de germanium monocristallin 10 recouvrant une couche sacrificielle 20, ici en oxyde de silicium, qui repose sur une couche support 30, ici en silicium. La couche support 30 en silicium peut être une couche d'un substrat de type SOI (pour *Silicon On Insulator*). La couche 10 est dite couche de germination dans la mesure où son matériau est adapté à la croissance épitaxiale ultérieure d'une portion semiconductrice. La surface libre, c'est-à-dire exposée, de la couche de germanium peut ensuite être nettoyée par gravure ionique réactive (ou gravure RIE, pour *Reactive Ion Etching* en anglais) éventuellement suivie d'un polissage mécano-chimique (ou CMP, pour *Chemical Mechanical Polishing* en anglais).

De manière alternative, on peut réaliser l'empilement par croissance épitaxiale d'une couche de germanium sur un substrat, la couche de germanium étant ensuite recouverte d'une couche d'oxyde de silicium. On solidarise cet empilement par collage moléculaire avec un second empilement formée d'une couche de silicium recouverte d'une couche d'oxyde de silicium, le collage étant réalisé par mise en contact mutuel des couches d'oxyde de silicium. On supprime ensuite totalement le substrat, par exemple par meulage (*grinding,* en anglais), de manière à obtenir ainsi la couche de germination en germanium liée à une couche support de silicium par une couche sacrificielle d'oxyde de silicium. Cette approche est notamment décrite dans la publication de Jan et al. intitulée Tensile-strained germanium-on-insulator substrate for silicon-compatible optoelectronics, Opt. Mater. Express 1, 1121-1126 (2011).

La couche de germination peut présenter, selon les applications électroniques ou optoélectroniques visées, une épaisseur de l'ordre de quelques dizaines de nanomètres à quelques microns. La couche sacrificielle peut présenter une épaisseur de l'ordre de quelques dizaines de nanomètres à quelques microns. La couche support peut présenter une épaisseur de quelques dizaines de nanomètres à quelques centaines de microns.

La réalisation de la couche de germination 10 d'épaisseur voulue au moyen du procédé décrit dans la publication de Reboud et al. 2015 est particulièrement avantageuse dans la mesure où la qualité cristalline de la couche de germination 10 est particulièrement élevée et sensiblement homogène suivant l'épaisseur de la couche. A titre d'exemple, la densité de dislocations peut être inférieure à 10$^7$ cm$^{-2}$ sur toute l'épaisseur de la couche, en particulier au niveau de l'interface avec la couche sacrificielle 20.

La couche de germination 10 présente ici un paramètre de maille naturel inférieur à celui de la portion semiconductrice à épitaxier. De plus, elle présente une contrainte en tension non nulle, c'est-à-dire que la contrainte de la couche semiconductrice, dans le plan XY de la couche, présente une valeur initiale $\sigma_{pc}^{i}$ non nulle et positive. Ici, la valeur initiale $\sigma_{pc}^{i}$ de contrainte de la couche de germination 10 n'est pas suffisante pour que son paramètre de maille soit sensiblement égal au paramètre de maille naturel de la portion semiconductrice à épitaxier.

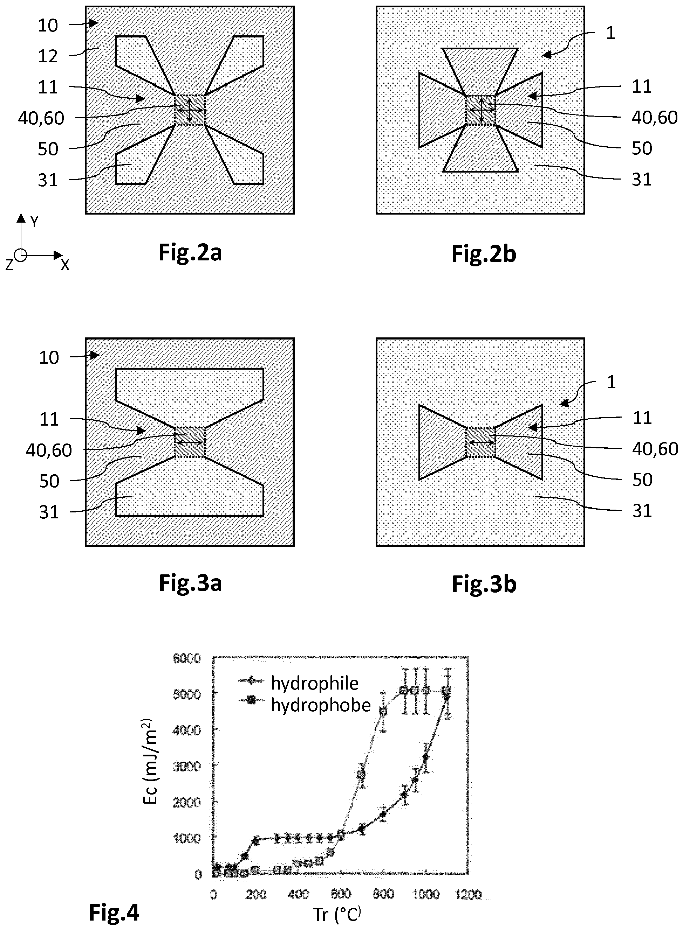

Selon une deuxième étape (non représentée sur la figure 1a), on structure la couche de germination 10 de manière à ce qu'elle présente une partie structurée 11 et une partie périphérique 12, la partie structurée 11 comportant une portion centrale 40 reliée à la partie périphérique 12 qui entoure ici la partie structurée 11. Dans cet exemple, des portions latérales 50 relient la portion 40 de la partie périphérique 12 (cf. par exemple figures 1b, 2a ou 3a). La partie structurée 11 est réalisée par des étapes classiques de lithographie puis de gravure de la couche de germination 10, qui ne sont donc pas détaillées ici. Comme le montre la figure 2a ou 3a, la portion centrale 40 peut présenter une forme, dans le plan (X,Y), sensiblement carrée ou rectangulaire, de quelques centaines de nanomètres à quelques microns de côté. D'autres formes sont possibles, telles que des formes allongées voire polygonales.

Au moins deux portions latérales 50 sont ici réalisées qui relient chacune une bordure de la portion centrale 40 à la partie périphérique 12. Elles sont agencées deux à deux vis-à-vis de la portion centrale 40 de manière à définir au moins un axe de déformation sensiblement rectiligne. Dans l'exemple de la figure 2a, deux paires de portions latérales 50 sont représentées où ces dernières s'étendent chacune à partie d'une bordure de la portion centrale 40 de forme sensiblement carrée jusqu'à la partie périphérique 12. Les portions latérales 50 sont agencées deux à deux de manière à définir ici deux axes de déformation sécants l'un avec l'autre au niveau de la portion centrale 40. Ainsi, une déformation biaxiale de la portion centrale 40, orientée suivant les deux axes de déformation, est en mesure d'être générée lorsque la partie structurée 11 sera suspendue lors d'une étape ultérieure. Dans l'exemple de la figure 3a, une unique paire de portions latérales 50 est représentée où ces dernières sont agencées de manière à définir un unique axe de déformation de la portion centrale 40. Ainsi, une déformation uniaxiale est en mesure d'être générée dans la portion centrale 40 lors d'une étape ultérieure.

La portion centrale 40 est destinée à devenir une portion contrainte, ici en tension, donc présentant une déformation de sa structure cristallographique par augmentation de son paramètre de maille. Les portions latérales 50 sont ainsi destinées à mettre en tension la portion centrale 40, de préférence sans pour autant subir elles-mêmes une contrainte mécanique significative. Pour cela, on forme les portions latérales 50, ou bras tenseurs, et la portion centrale 40 pour que la largeur moyenne « b » des bras tenseurs 50 soit supérieure à la largeur moyenne « a » de la portion centrale 40, de préférence dix fois supérieure à cette dernière. Par largeur, on entend la dimension transversale d'une portion ou d'un bras, dans le plan (X,Y), à son axe longitudinal. La portion centrale 40 présente ici une largeur moyenne « a » orientée suivant l'axe Y et sensiblement constante suivant l'axe longitudinal X. Les bras tenseurs 50 présentent une largeur moyenne « b » orientée ici suivant l'axe Y. En outre, la dimension surfacique dans le plan (X,Y), et en particulier la largeur de chaque portion latérale 50, c'est-à-dire la dimension transversale sensiblement orthogonale à l'axe de déformation, est choisie de sorte que la portion latérale 50 ne présente sensiblement pas ou peu de déformation. Plus précisément, la déformation moyenne, dans l'épaisseur de la portion latérale 50, diminue à mesure qu'on s'éloigne de la portion contrainte 40 et devient négligeable à une distance supérieure ou égale à une ou deux fois la dimension de la portion contrainte 40. La largeur moyenne de chaque portion latérale est supérieure à la largeur moyenne de la portion centrale, de préférence dix fois supérieure à cette dernière. La déformation moyenne de la portion latérale 50, c'est-à-dire le champ de déformation intégré dans le volume de la portion latérale présente une valeur inférieure à celle de la portion contrainte, voire est négligeable vis-à-vis de la déformation moyenne dans la portion contrainte. Sur les exemples des figures 2a et 3a, les portions latérales 50 présentent une forme de trapèze de sorte que la largeur augmente à mesure que l'on s'éloigne de la portion centrale 40. D'autres formes sont possibles, par exemple une forme où les portions latérales présentent une augmentation brusque de largeur vis-à-vis de la portion centrale puis une zone principale à largeur constante.

La structuration peut être réalisée de manière à contrôler la valeur de l'amplification de la contrainte en tension de la portion centrale 40 de la couche de germination 10, obtenue ultérieurement lors de la réalisation de la cavité. Pour cela, on prédétermine les paramètres dimensionnels de la partie structurée 11, par exemple les largeurs et longueurs de la portion centrale 40 et des bras tenseurs 50. A titre d'exemple, dans le cas d'une portion centrale 40 rectangulaire, de longueur A et de largeur constante a, et des bras tenseurs 50 rectangulaires de longueur B/2-A/2 et de largeur constante b, un facteur d'amplification f reliant la contrainte finale en tension $\sigma_{pc}^{f}$ à la contrainte initiale en tension $\sigma_{pc}^{i}$ peut s'exprimer par la relation suivante formulée dans l'article de Süess et al intitulé Analysis of enhanced light emission from highly strained germanium microbridges, Nature Photon. 7, 466-472 (2013) :

$$f = \frac{2L+B}{B}\left(1 + \frac{A}{B-A}\right)/\left(\frac{a}{b} + \frac{A}{B-A}\right)$$

où L est la longueur de la couche sacrificielle 20 supprimée sous la partie structurée 11 lors de l'étape ultérieure de réalisation de la cavité. Ainsi, en fonction des paramètres dimensionnels de la partie structurée 11 de la couche de germination 10, on est en mesure de contrôler la valeur de l'amplification de la contrainte en tension appliquée à la portion centrale 40 lors de la réalisation de la cavité. Le facteur d'amplification peut également être estimé au moyen d'un logiciel de simulation numérique tel que COMSOL Multiphysics.

Ainsi, on obtient une couche de germination 10 structurée localement recouvrant la couche sacrificielle 20. La couche de germination 10 présente une partie structurée 11 comportant une portion centrale 40, ici reliée par des portions latérales 50 à une partie périphérique 12 de la couche 10. La portion centrale 40 est destinée à subir une contrainte en tension issue d'une déformation générée par les portions latérales 50.

Selon une troisième étape illustrée sur les figures 1b et 1c, on réalise une cavité sous la partie structurée de la couche de germination en rendant libre une surface de la couche support située en regard de la partie structurée, de manière à la suspendre au-dessus de cette surface libre. La portion centrale est alors mise en contrainte, ici en tension par les portions latérales. Puis, selon l'invention, on effectue la mise en contact de la partie structurée suspendue avec la surface libre de la couche support. Une surface dite libre ou rendue libre est une surface exposée sur laquelle un matériau peut être déposé.

Dans un premier temps, comme illustré sur la figure 1b, la cavité 21 est réalisée par gravure humide de la couche sacrificielle 20 rendue accessible par des ouvertures obtenues lors de la structuration de la couche de germination 10. La gravure humide utilise ici de l'acide fluorhydrique (également appelé HF, pour *Hydrogen Fluoride* en anglais) en phase vapeur. Le flux de vapeur HF peut être faible de manière à graver la couche sacrificielle à une vitesse modérée de l'ordre de 10nm par minute. Plus précisément, le flux de vapeur peut, à titre d'exemple, comporter de l'acide fluorhydrique à 15 torr de pression partielle, de l'alcool à 0,01 torr et de l'azote à 60 torr. Ainsi, on grave sur toute son épaisseur la partie de la couche sacrificielle 20 située sous la partie structurée 11 de la couche de germination 10. La partie structurée 11 est alors suspendue au-dessus de la surface rendue libre 31 de la couche support 30, formant ainsi une cavité 21. La cavité 21 est donc située entre la partie structurée 11 et la surface libre 31 de la couche support 30.

On obtient ainsi une partie structurée 11 suspendue, qui prend la forme d'une membrane suspendue, dont les portions latérales 50 forment maintenant des bras tenseurs qui maintiennent la portion centrale 40 au-dessus de la surface libre 31 de la couche support 30 et génèrent dans la portion centrale 40 une contrainte mécanique en tension orientée suivant les axes de déformation. La surface inférieure 13 de la partie structurée 11 et la surface libre 31 de la couche support 30 présentent ici une rugosité inférieure ou égale à 10nm RMS environ, propice au collage moléculaire effectué lors d'une étape ultérieure. Les dimensions respectives de la portion centrale 40 et des portions latérales 50 sont telles que les bras tenseurs génèrent une contrainte en tension dans la portion contrainte sensiblement égale à une valeur prédéterminée de déformation. Dans la suite de la description, la portion centrale 40 est appelée portion contrainte de germination et les portions latérales 50 sont appelées bras tenseurs.

Dans un second temps, et selon l'invention, comme illustré sur la figure 1c, on réalise la mise en contact de la membrane suspendue 11, plus précisément de la portion contrainte 40 et d'au moins une partie des bras tenseurs 50, de manière à rendre solidaire la partie structurée 11 avec la surface libre 31 de la couche support.

Pour cela, on immerge ici la partie structurée 11 dans une solution liquide, par exemple d'alcool ou d'eau déionizée acidifiée (pH proche de 2), puis on évapore le liquide. Lors de la phase d'évaporation, la partie structurée 11 suspendue vient naturellement au contact de la surface libre 31 de la couche support. Ainsi, elle repose sur la couche support, de sorte que la surface inférieure d'au moins une partie des bras tenseurs 50 est au contact avec la surface libre 31. La surface inférieure de la portion contrainte 40 peut être totalement, partiellement, ou pas au contact de la surface libre 31.

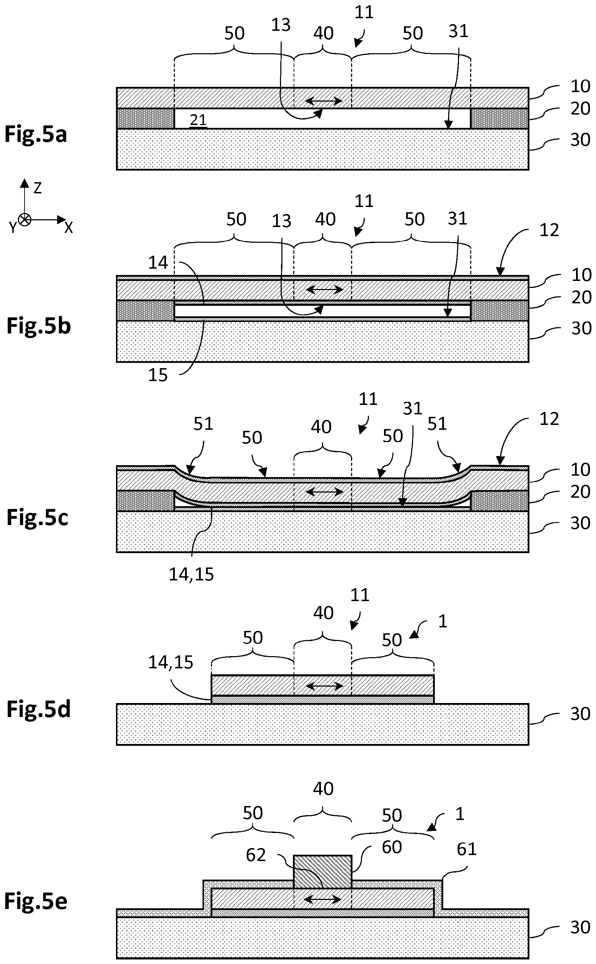

La mise en contact de ces surfaces assure un collage direct, ici de type hydrophobe, de la partie structurée 11 avec la couche support 30. Le collage direct est ici de type hydrophobe dans la mesure où les surfaces se solidarisent l'une à l'autre par l'intermédiaire de liaisons hydrogène. A température ambiante, comme l'illustre la figure 5 représentant l'évolution de l'énergie surfacique de collage hydrophobe entre les surfaces collées, l'énergie de collage hydrophobe est ici de l'ordre de 5mJ/m$^2$.

La partie structurée 11 est solidaire de la couche par collage direct, également appelé collage moléculaire ou collage par adhérence moléculaire, c'est-à-dire que la solidarisation de surfaces est réalisée sans apport de couche collante (de type colle, glue, etc...) mais par le biais des forces attractives d'interaction atomique ou moléculaire entre les surfaces, par exemple des forces de Van der Walls, des liaisons hydrogène, voire des liaisons covalentes. Comme il est détaillé par la suite, le collage moléculaire peut être de type hydrophile ou hydrophobe. Le collage est de type hydrophile lorsqu'il concerne l'adhérence de surfaces hydrophiles, c'est-à-dire de surfaces ayant la capacité à se lier avec des molécules d'eau par un mécanisme d'adsorption. Le collage met alors en jeu des forces de liaison hydrogène dont l'intensité d'interaction est particulièrement élevée. Pour cela, les surfaces hydrophiles sont terminées par des groupements hydroxyles (-OH). Alternativement, le collage peut être de type hydrophobe et concerner alors des surfaces qui n'ont pas la capacité d'adsorber de l'eau. Pour cela, les surfaces hydrophobes peuvent être saturées d'atomes tels que l'hydrogène ou le fluor.

Par mise en contact, on entend le contact de la surface inférieure 13 de la partie structurée avec la surface rendue libre 31 de la couche support. Ces surfaces peuvent être formées du matériau composant principalement les couches ou d'un matériau intercalaire différent de ce matériau principal. La couche de germination et la couche support peuvent ainsi comporter une couche mince d'un matériau intercalaire obtenu par exemple par dépôt ou par oxydation, de préférence après formation de la cavité. Dans le procédé décrit ici faisant intervenir le collage hydrophobe, la couche de germination et la couche support ne comporte pas de matériau intercalaire.

On obtient ainsi une partie structurée 11 de la couche de germination 10, solidaire de la surface libre 31 de la couche support 30, ici par collage moléculaire de type hydrophobe. La partie non collée des bras tenseurs 50 est située dans la zone 51, dite distale, où ceux-ci rejoignent la partie périphérique 12 de la couche de germination 10, cette dernière reposant sur la partie non gravée de la couche sacrificielle 20.

En variante, l'étape de de réalisation de la cavité 21 et de mise en contact de la partie structurée 11 avec la surface libre 31 de la couche support peut être réalisée dans le même temps. Pour cela, la cavité 21 est par exemple réalisée par gravure humide par HF liquide voire par HF vapeur en haute pression. Dans le cas d'une gravure par HF vapeur, le flux de vapeur peut comporter de l'acide fluorhydrique à 60 torr de pression partielle, de l'alcool à 0,1 torr et de l'azote à 75 torr. Le flux de gaz conduit alors à une vitesse de gravure plus importante que celle mentionnée précédemment, par exemple de l'ordre de 100nm/min, lors d'une réaction de gravure hors-équilibre. Aussi, des gouttes d'eau et d'acide fluorhydrique, produits de la réaction chimique, se forment dans la cavité et provoquent, en évaporant, la mise en contact de la partie structurée avec la surface libre de la couche support.

Selon une quatrième étape illustrée sur les figures 1d, on forme une portion semiconductrice 60 par croissance épitaxiale sur la portion contrainte de germination 40.

Dans l'exemple représenté, la portion semiconductrice 60 est localisée uniquement en regard de la portion contrainte de germination 40. Pour cela, on dépose un masque de croissance 61 de manière à recouvrir la partie structurée 11 ainsi que la partie périphérique 12, puis on réalise une ouverture rendant libre, c'est-à-dire exposée, une surface supérieure 62 de la portion contrainte de germination, dite alors surface de germination.

La portion semiconductrice, par exemple en germanium-étain $Ge_{1-x}Sn_x$, est ensuite formée par épitaxie sur la surface de germination de la portion contrainte. Elle peut être formée par des techniques de dépôt chimique en phase vapeur (CVD, acronyme anglais pour *Chemical Vapor Deposition*), telles que le dépôt chimique à basse pression (LPCVD, pour *Low Pressure Chemical Vapor Deposition*), le dépôt chimique en phase vapeur organométallique (MOCVD, pour *Metal-Organic Chemical Vapor Deposition*), le dépôt chimique en phase vapeur assisté par plasma (PECVD, pour *Plasma-Enhanced Chemical Vapor Deposition*), l'épitaxie en phase vapeur aux hydrures (HVPE, pour *Hydride Vapor Phase Epitaxy*), voire également la pulvérisation cathodique réactive (*sputtering* en anglais). Des techniques telles que l'épitaxie par jets moléculaires (MBE, pour *Molecular-Beam Epitaxy*) ou l'épitaxie en phase liquide (LPE, pour *Liquid Phase Epitaxy*) peuvent également être utilisées.

On obtient ainsi une portion semiconductrice épitaxiée sur une portion contrainte de germination, elle-même reposant sur une couche support. Elle est donc solidaire de la couche support et en est espacée essentiellement par la présence de la portion contrainte de germination. L'absence de cavité entre la portion de germination et la couche support facilite la réalisation d'opérations ultérieures classiques de la microélectronique, telles que le dépôt de couches minces, la lithographie, la gravure, voire le dopage de couches. Cela permet ainsi la réalisation ultérieure de dispositifs microélectronique ou optoélectronique comporte une telle portion semiconductrice épitaxiée.

Par ailleurs, l'absence de cavité assure une meilleure maîtrise de l'épitaxie de la portion semiconductrice, en écartant les risques de croissance non désirée à l'intérieur de la cavité. Par ailleurs, l'épitaxie est mieux contrôlée dans la mesure où la portion de germination repose sur la couche support, ce qui assure un contact thermique direct entre ces deux éléments et donc une meilleure maîtrise de la température d'épitaxie au niveau de la portion de germination. Enfin, l'absence de cavité augmente la proximité entre la portion semiconductrice épitaxiée et la couche support et rend possible un éventuel couplage optique entre la portion semiconductrice formant par exemple le milieu à gain d'une source de lumière cohérence avec un guide d'onde disposé au niveau de la couche support, celle-ci formant alors une couche d'une plateforme photonique à base de silicium.

De plus, la maîtrise de la déformation de la structure cristallographique de la portion contrainte de germination par les bras tenseurs permet d'obtenir l'absence ou non de contraintes dans la portion semiconductrice. Il est avantageux que la portion semiconductrice soit épitaxiée en accord de maille, de sorte que la structure cristallographique ne soit pas déformée lors de la croissance épitaxiale. Le paramètre de maille effectif de la portion contrainte de germination étant alors sensiblement égal au paramètre de maille naturel de la portion semiconductrice épitaxiée. Ainsi, l'absence de contraintes dans la portion semiconductrice permet de limiter les risques de relaxation plastique et donc de formation de défauts structuraux de type dislocations de désaccord de maille. Ainsi, la portion semiconductrice présente des propriétés électroniques et/ou optiques optimales.

Selon une cinquième étape facultative, comme l'illustre la figure 1e, on individualise la structure formée de la portion semiconductrice 60 épitaxiée recouvrant la portion contrainte de germination 40, et d'au moins une partie des bras tenseurs 50, c'est-à-dire qu'on la sépare de la partie périphérique 12 de la couche de germination 10. Par séparer, rendre distincte ou individualiser, on entend ici que la partie structurée 11 n'est plus reliée à la partie périphérique 12 par les bras tenseurs 50, par gravure d'une partie distale 51 des bras tenseurs 50. La portion distale 51 des bras tenseurs correspond à la zone des bras tenseurs 50 éloignée de la portion contrainte 40 et formant le raccord avec la partie périphérique 12.

A l'issue de l'étape de croissance épitaxiale, l'empilement formé de la partie structurée 11 collée, comportant la portion contrainte 40 et les bras tenseurs 50 reposant sur la couche support 30, sur laquelle est située la portion épitaxiée 60, présente :

◦ une énergie de collage Ec, issue du collage moléculaire hydrophobe sur la couche support. Elle peut être estimée, au premier ordre, par la relation :

$$E_c \approx E_s\big(S_{bt} + S_{pc}\big) \qquad (1)$$

où Es est l'énergie de surface évaluée à partir de la relation illustrée sur la fig.4, et $S_{bt}$ et $S_{pc}$ sont les surfaces respectives des bras tenseurs et de la portion contrainte. L'énergie de collage tend à stabiliser la partie structurée collée et à éviter toute relaxation des contraintes susceptibles de modifier sa tenue mécanique ;
∘ une énergie élastique Ee, issue de la contrainte mécanique en tension liée à la déformation de la portion contrainte par les bras tenseurs. Elle peut être estimée par la relation :

$$E_e \approx \frac{1}{2} \iiint_{x,y,z} E.\,\varepsilon^2 \mathrm{dxdydz} \qquad (2)$$

où E est le module d'Young local et $\varepsilon$ la déformation locale subie par la structure semiconductrice (formée de la portion contrainte 40, de la portion épitaxiée 60, et des portions latérales 50). L'énergie élastique tend à déstabiliser la structure semiconductrice collée de manière à relaxer naturellement les contraintes.

On peut noter que, au premier ordre, l'énergie de collage comporte un terme prépondérant lié à la surface collée des bras tenseurs, celle-ci est généralement supérieure à la surface collée de la portion contrainte. Par ailleurs, l'énergie élastique comporte un terme prépondérant lié à la déformation de la portion contrainte, dans la mesure où les bras tenseurs présentent une valeur moyenne de déformation proche de la valeur de déformation résiduelle, celle-ci étant inférieure à la valeur de la déformation subie par la portion contrainte.

Dans le but de réaliser une partie structurée 11 dont la tenue mécanique est préservée, et qui puisse être séparée de la partie périphérique 12, l'énergie de collage doit être supérieure à l'énergie élastique, ce qui se traduit au premier ordre par l'inégalité suivante :

$$E_c(E_s^{min}; S_{bt}^{min}) > E_e(S_{bt}^{min}) \qquad (3)$$

Pour cela, tout d'abord on détermine à la fois la valeur minimale d'énergie surfacique de collage $E_s^{min}$ et la valeur minimale de surface collée $S_{bt}^{min}$ des bras tenseurs, nécessaires pour vérifier cette inégalité. Bien entendu, cette inégalité peut être précisée en utilisant des expressions de l'énergie de collage et de l'énergie élastique plus détaillées, par exemple en intégrant le champ de contrainte dans tout le volume de la partie structurée collée, en tenant compte de la présence de la portion semiconductrice épitaxiée, au moyen par exemple d'un logiciel de calcul des contraintes à base par exemple d'élément finis tel que COMSOL Multiphysics®.

Ainsi, à titre illustratif, pour une portion semiconductrice de GeSn épitaxiée en accord de maille sur une portion contrainte de germination 40 en germanium d'une surface $S_{pc}$ de $5\mu m^2$ présentant une déformation moyenne uniaxiale de 5,7%, d'épaisseur e de 300nm, le module Young étant égal à 100GPa environ, et les bras tenseurs 50 présentant une déformation moyenne proche de la valeur résiduelle de 0,2%, et enfin pour une énergie surfacique de collage $E_s$ de $100mJ/m^2$, il ressort que la surface collée minimale $S_{bt}$ des bras tenseurs est égale à environ $6550\mu m^2$. On remarque qu'en appliquant un traitement thermique à 600°C pendant quelques minutes à quelques heures, l'énergie surfacique de collage hydrophobe $E_s$ passe à $1J/m^2$, ce qui permet alors d'obtenir une surface collée minimale $S_{bt}^{min}$ des bras tenseurs d'environ $290\mu m^2$. De préférence, chacun des deux bras tenseurs présente alors une surface collée minimale $S_{bt}^{min}$ de $145\mu m^2$.

Ensuite, un renforcement du collage moléculaire de la partie structurée 11 solidaire de la surface libre 31 de la couche support 30 peut être nécessaire, de manière à obtenir une valeur Es d'énergie surfacique de collage supérieure ou égale à la valeur minimale $E_s^{min}$ déterminée préalablement. Pour cela, on réalise un traitement thermique, par exemple sous forme d'un recuit de consolidation, dans lequel on soumet l'empilement à une température de recuit Tr pendant quelques minutes à quelques heures. A titre illustratif, la température de recuit peut être de 200°C appliquée pendant 2h, ce qui augmente ici l'énergie surfacique de collage hydrophobe de $5mJ/m^2$ à $100mJ/m^2$. La température de recuit est comprise entre une valeur minimale qui dépend notamment de la surface minimale collée $S_{bt}^{min}$ de bras tenseurs que l'on souhaite conserver et une valeur maximale qui dépend notamment de la qualité cristallographique à préserver des différents matériaux de l'empilement. La valeur maximale de la température de recuit peut ainsi être inférieure à la température de sublimation des différentes couches et portions présentes.

Ce traitement thermique peut être une sous-étape spécifique de recuit de consolidation réalisée à la suite de l'étape de croissance épitaxiale de la portion semiconductrice. En variante, et de manière avantageuse, ce traitement thermique n'est pas une sous-étape spécifique, mais est réalisé naturellement lors de l'étape de croissance épitaxiale. En effet, la température d'épitaxie atteint une valeur supérieure ou égale à la température de recuit Tr mentionnée précédemment. A titre d'exemple, la température d'épitaxie peut être de 600°C alors que la valeur minimale de température de recuit est de 200°C. Ainsi, à la suite de l'étape d'épitaxie de la portion semiconductrice 60, la partie structurée 11 sur laquelle repose la portion épitaxiée 60 présente une valeur Es d'énergie surfacique de collage supérieure ou égale à la valeur minimale minimale $E_s^{min}$ prédéterminée. Une sous-étape spécifique de recuit de consolidation n'est alors pas nécessaire.

Ainsi, on obtient une structure semiconductrice collée à la couche support 30 avec une énergie de collage Ec dont la valeur est supérieure ou égale à la valeur minimale prédéterminée. On est alors en mesure de supprimer une partie des bras tenseurs 50 pour séparer la partie structurée 11 de la partie périphérique 12.

Enfin, on retire, par gravure, une portion distale 51 des bras tenseurs 50 de manière à séparer, ou individualiser, la partie structurée 11 vis-à-vis de la partie périphérique 12. On supprime, par des opérations classiques de lithographie optique et/ou électronique et de gravure, la portion distale 51 des bras tenseurs de manière à ce que la partie structurée 11 collée comporte une valeur de surface collée $S_{bt}$ des bras tenseurs supérieure ou égale à la valeur minimale $S_{bt}^{min}$ déterminée préalablement. Par portion distale 51 des bras tenseurs, on entend la zone des bras tenseurs 50 éloignée de la portion contrainte 40 et formant le raccord avec la partie périphérique 12. Ainsi, la surface collée des bras tenseurs 50 est suffisante pour que la partie structurée 11 collée présente une énergie de collage supérieure à son énergie élastique.

Ainsi, on obtient une structure semiconductrice 1 à portion épitaxiée 60 sur une portion contrainte de germination 40 collée sur la couche support 30 dont la tenue mécanique est assurée. La structure semiconductrice 1 présente une qualité cristalline élevée, et la portion épitaxiée 60 peut présenter ou non une déformation de sa structure cristallographique. La portion contrainte de germination 40 est solidarisée de la couche support 30 par collage moléculaire dont l'énergie de collage et la surface collée des bras tenseurs 50 permettent de figer le champ des contraintes.

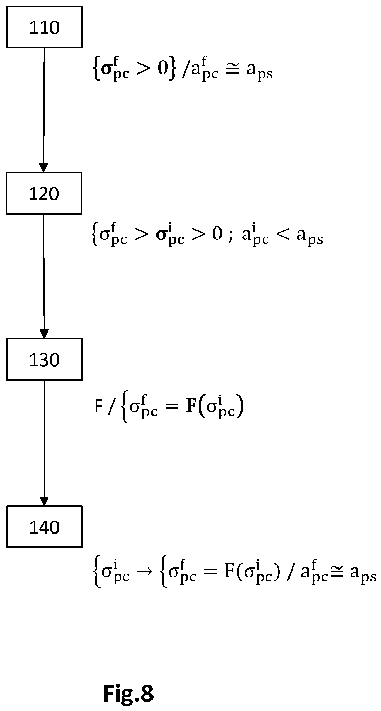

La figure 8 illustre un organigramme d'un procédé selon un mode de réalisation, permettant d'obtenir une portion centrale 40 de la couche de germination 10 dont le paramètre de maille est sensiblement égal au paramètre de maille naturel de la portion semiconductrice 60.

Lors d'une première étape 110, on estime, pour la couche de germination 10, une valeur finale $\sigma_{pc}^f$ de contrainte en tension pour laquelle le paramètre de maille de la couche de germination 10 présente une valeur finale $a_{pc}^f$ sensiblement égale au paramètre de maille naturelle $a_{ps}$ de la portion semiconductrice 60.

Lors d'une deuxième étape 120, on fournit l'empilement dans lequel la couche de germination 10 présente une contrainte en tension dans le plan (X,Y) de valeur initiale $\sigma_{pc}^i$ non nulle et positive, mais inférieure à $\sigma_{pc}^f$. La couche semiconductrice 10 présente alors un paramètre de maille d'une valeur initiale $a_{pc}$ inférieure à la valeur $a_{ps}$.

Lors d'une troisième étape 130, on détermine puis on réalise une structuration de la couche de germination 10 de manière à former la partie structurée 11 décrite précédemment. La structuration est déterminée de sorte que la formation de la cavité 21 sous-jacente de la partie structurée 11 provoque l'augmentation de la contrainte en tension de la portion centrale 40, qui passe alors de la valeur initiale $\sigma_{pc}^i$ à la valeur finale $\sigma_{pc}^f$. Pour cela, on note F la fonction de transfert permettant de passer de $\sigma_{pc}^i$ à $\sigma_{pc}^f$, autrement dit : $\sigma_{pc}^f = F(\sigma_{pc}^i)$. La fonction de transfert F est paramétrée essentiellement par les dimensions de la partie structurée 11, et notamment par la largeur moyenne des bras tenseurs 50 et celle de la portion centrale 40. La fonction de transfert peut être identique ou similaire au facteur d'amplification f mentionné précédemment. On détermine donc les paramètres de la fonction de transfert F, par exemple par simulation numérique à l'aide du logiciel COMSOL Multiphysics ou en vérifiant la relation mentionnée précédemment.

Lors d'une quatrième étape 140, on forme la cavité 21 sous la partie structurée 11 par gravure partielle de la couche sacrificielle 20. Ainsi, la portion centrale 40 passe de la valeur initiale $\sigma_{pc}^i$ à la valeur finale $\sigma_{pc}^f = F(\sigma_{pc}^i)$ de contrainte en tension dans le plan (X,Y). On obtient ainsi une couche centrale de germination 40 qui présente une valeur $a_{pc}^f$ du paramètre de maille sensiblement égale à la valeur naturelle $a_{ps}$ du paramètre de maille de la portion semiconductrice 60. Aussi, lors de l'étape de croissance épitaxiale, la portion semiconductrice 60 croît de manière sensiblement relaxée.

Les figures 2a et 2b illustrent deux étapes du procédé décrit précédemment correspondant respectivement aux figures 1e et 1e. Sur la figure 2a est illustrée la partie structurée 11 collée par adhérence moléculaire à la surface rendue libre 31 de la couche support 30. La portion contrainte de germination 40 est reliée à la partie périphérique 12

de la couche de germination 10 par l'intermédiaire des bras tenseurs 50. Deux paires de bras tenseurs 50 de dimensions identiques sont représentées, ce qui induit une déformation biaxiale de la portion contrainte 40, d'intensité sensiblement égale selon les deux axes de déformation ici respectivement parallèles aux axes X et Y. En variante, chaque paire de bras tenseurs peut présenter des dimensions différentes, de manière à déformer la portion contrainte 40 avec une intensité différente suivant chacun des axes de déformation. La portion semiconductrice 60 est épitaxiée à partir de la surface de germination de la portion contrainte 40. Sur la figure 2b est illustrée la structure semiconductrice 1 à portion épitaxiée 60 sur la portion contrainte de germination 40, obtenue en séparant la partie structurée 11 de la partie périphérique 12, par gravure de la zone distale des bras tenseurs 50 faisant raccord avec la partie périphérique 12.

Les figures 3a et 3b sont similaires aux figures 2a et 2b et s'en distinguent essentiellement en ce que la partie structurée 11 comporte une unique paire de bras tenseurs 50 assurant la mise en tension uniaxiale de la portion contrainte 40. Cette dernière subit alors une déformation uniaxiale suivant l'axe de déformation définie par l'agencement des bras tenseurs 50 vis-à-vis de la portion contrainte 40. La figure 3a illustre la partie structurée 11 collée par adhérence moléculaire à la surface rendue libre 31 de la couche support 30, où les bras tenseurs 50 relient la portion contrainte 40 à la partie périphérique 12. La figure 3b illustre la structure semiconductrice 1 obtenue à partir de la partie structurée 11 collée en gravant la zone de raccord des bras tenseurs 50 à la partie périphérique (celle-ci étant également supprimée).

La figure 4 illustre un exemple de relation entre l'énergie surfacique de collage entre une surface de germanium et une surface de silicium en fonction de la température de recuit, dans le cas d'un collage de type hydrophile et d'un collage de type hydrophobe. Jusqu'à 600°C environ, l'énergie surfacique de collage présente une valeur inférieure dans le cas hydrophobe que dans le cas hydrophile. La tendance s'inverse ensuite à partir de 600°C environ. Par ailleurs, dans le cas hydrophile, l'énergie surfacique augmente dès qu'un recuit à 100°C environ est appliqué, et l'on passe d'une énergie de l'ordre de $100mJ/m^2$ à température ambiante à $1J/m^2$ après un recuit à 200°C environ. Dans le cas hydrophobe, on passe d'une énergie de l'ordre de $5mJ/m^2$ à température ambiante à $100mJ/m^2$ après un recuit à 200°C environ.

Les figures 5a à 5e illustrent un procédé de réalisation de la structure semiconductrice à portion contrainte selon un second mode de réalisation. Ce procédé se distingue du premier mode de réalisation décrit en référence aux figures 1a à 1e essentiellement en ce que le collage moléculaire est de type hydrophile d'une part, et en ce que la gravure de la partie distale 51 des bras tenseurs 50 est effectuée avant épitaxie de la portion semiconductrice 60 d'autre part.

Les étapes de fourniture d'un empilement formé d'une couche de germination 10 solidaire d'une couche support 30 par une couche sacrificielle 20, puis la structuration de la couche de germination 10 de manière à former une partie structurée 11 et une partie périphérique 12 sont identiques à celles décrites précédemment, et ne sont pas détaillées ici davantage.

La figure 5a illustre la réalisation d'une cavité 21 située sous la partie structurée 11, de manière à suspendre la partie structurée 11 au-dessus d'une surface rendue libre 31 de la couche support 30. Comme mentionné précédemment, la cavité 21 peut être réalisée par gravure humide avec un flux de vapeur d'acide fluorhydrique (HF) faible de manière à graver la couche sacrificielle à une vitesse modérée de l'ordre de 10nm par minute. Plus précisément, le flux de vapeur peut, à titre d'exemple, comporter de l'acide fluorhydrique à 15 torr de pression partielle, de l'alcool à 0,01 torr et de l'azote à 60 torr. Ainsi, on grave sur toute son épaisseur la partie de la couche sacrificielle 20 située sous la partie structurée 11. La partie structurée 11 est alors suspendue au-dessus de la surface rendue libre 31 de la couche support, formant ainsi une cavité 21.

La figure 5b illustre une étape de traitement de surface de la partie structurée 11 et de la surface libre 31 de la couche support, dans le but d'assurer ultérieurement le collage moléculaire hydrophile de ces éléments. Lors de cette étape, on traite la surface 13 de la partie structurée 11 en regard de la cavité 21 et la surface libre 31 de la couche support de sorte qu'elles soient formées chacune d'une couche mince 14, 15 d'oxyde ou de nitrure, d'une épaisseur de quelques nanomètres à quelques dizaines de nanomètres.

Selon une variante, la partie structurée 11 et la couche support 30 sont recouvertes, au niveau de la cavité 21, d'une couche mince d'oxyde 14, 15 réalisée par oxydation. Les couches minces d'oxyde 14, 15 peuvent être obtenues par mise à l'air libre de cette zone de l'empilement pendant une durée suffisante, par exemple 1h. Elles peuvent également être obtenues par une technique d'oxydation par plasma $O_3$, par exemple à température ambiante, voire par une technique d'oxydation par plasma $O_2$, par exemple à une température de 250°C. Dans le cadre de l'exemple préféré, la partie structurée en germanium monocristallin présente une surface inférieure 13 formée d'une couche mince d'oxyde de germanium 14 d'une épaisseur de l'ordre de quelques nanomètres à quelques dizaines de nanomètres, et la surface libre 31 de la couche support en silicium est formée d'une couche mince d'oxyde de silicium 15 d'une épaisseur également de l'ordre de quelques nanomètres à quelques dizaines de nanomètres.

Selon une autre variante, la partie structurée 11 et la couche support 30 sont recouvertes, au niveau de la cavité 21, d'une couche mince d'oxyde ou de nitrure obtenue par une technique de dépôt de couche mince. Les couches sont, par exemple, déposées par une technique du type ALD (pour *Atomic Layer Deposition,* en anglais) assisté ou non par plasma. Le matériau déposé peut être un oxyde ou un nitrure de silicium, $SiO_2$ ou $Si_3N_4$, voire être un oxyde d'hafnium $HfO_2$, de titane $TiO_2$, voire d'aluminium $Al_2O_3$, ou tout autre matériau adapté. Ainsi, dans le cadre de l'exemple préféré, la partie structurée 11 en germanium monocristallin présente une surface inférieure 13 formée d'une couche mince, par exemple, d'oxyde de silicium d'une épaisseur de l'ordre de quelques dizaines de nanomètres, et la surface libre 31 de la couche support 30 en silicium est formée d'une couche mince d'oxyde de silicium d'une épaisseur également de l'ordre de quelques dizaines de nanomètres.

On obtient ainsi une partie structurée 11 sous forme d'une membrane suspendue qui comporte un matériau issu de l'oxydation ou de la nitruration effectuée au niveau de ses surfaces inférieure et supérieure. La surface inférieure 13 de la partie structurée et la surface libre 31 de la couche support présentent ici une rugosité inférieure ou égale à 10nm RMS environ, propice au collage moléculaire effectué lors d'une étape ultérieure.

En variante, la surface 31 de la couche support 30 peut être formée d'une couche supérieure (non représentée) en un oxyde thermique, c'est-à-dire obtenu par oxydation thermique. La vitesse de gravure humide HF de la couche sacrificielle 20, lorsque celle-ci est réalisée en un oxyde déposé, est supérieure à celle de la couche supérieure d'oxyde thermique. Ainsi, lors de l'étape de réalisation de la cavité 21, la couche sacrificielle est supprimée au niveau de la partie structurée 11 et la face supérieure 31 de la couche d'oxyde thermique est alors rendue libre. On est ainsi en mesure de contrôler l'épaisseur de la couche d'oxyde séparant la structure semiconductrice 1 vis-à-vis de la couche support 30. En variante, la couche sacrificielle peut comporter une sous-couche d'oxyde déposé, au contact de la couche de germination 10, et une sous-couche d'oxyde thermique sous-jacente, située entre la sous-couche d'oxyde déposé et la couche support 30 de silicium, les sous-couches étant avantageusement séparées par une couche mince d'arrêt de gravure.

La figure 5c illustre l'étape de mise en contact de la partie structurée 11 avec la surface libre 31 de la couche support. Pour cela, on immerge la partie structurée suspendue 11 dans une solution liquide, par exemple d'alcool ou d'eau déionizée acidifiée (pH proche de 2), puis on procède à l'évaporation du liquide. De préférence, on immerge la partie structurée 11 dans une solution liquide d'azote (par exemple à une température de 70K environ) ou d'hélium (par exemple à une température de 4K environ), puis on procède à l'évaporation du liquide. Lors de la phase d'immersion ou d'évaporation, la membrane suspendue 11 vient naturellement au contact de la surface libre 31 de la couche support. L'utilisation d'hélium ou d'azote (ou de tout autre liquide adéquat), donc associée à une diminution de la température préalablement à la mise en contact de la partie structurée 11 sur la couche support 30, permet de générer une mise en tension plus importante de la partie structurée 11. Ainsi, la partie structurée 11 repose sur la couche support 30, de sorte que la surface inférieure d'au moins une partie des bras tenseurs 50 est au contact avec la surface libre 31 de la couche support. La surface inférieure de la portion contrainte 40 peut être au contact totalement, partiellement, voire n'être pas au contact avec la surface libre 31.

La mise en contact de ces surfaces assure un collage direct de type hydrophile de la partie semiconductrice structurée sur la couche support. A température ambiante, comme l'illustre la figure 4, l'énergie de collage hydrophile est ici de l'ordre de 100mJ/m$^2$.

La mise en contact correspond ici au contact de la surface inférieure 13 de la partie structurée avec la surface libre 31 de la couche support, ces surfaces étant formées de la couche mince 14, 15 obtenue par oxydation ou par dépôt. Ainsi, une couche 14, 15 d'un matériau intercalaire est présente entre le matériau composant principalement la partie structurée 11 et le matériau composant principalement la couche support 30. Cette couche dite intercalaire 14, 15 présente une épaisseur de l'ordre de quelques dizaines de nanomètres à une ou plusieurs centaines de nanomètres. Elle est avantageusement diélectrique et peut ainsi assurer l'isolation électrique de la portion contrainte vis-à-vis de la couche support.

On effectue une étape de détermination de la valeur minimale d'énergie surfacique de collage $E_s^{min}$, ici hydrophile, et la valeur minimale de surface collée $S_{bt}^{min}$ des bras tenseurs, nécessaires pour que l'énergie de collage hydrophile de la partie structurée soit supérieure à l'énergie élastique de cette même partie structurée.

Ainsi, à titre illustratif, pour une portion contrainte de germanium de surface $S_{pc}$ de $5\mu m^2$ présentant une déformation moyenne uniaxiale de 5,7%, d'épaisseur e de 300nm, le module Young étant égal à 100GPa environ, et les bras tenseurs présentant une déformation moyenne proche de la valeur résiduelle de 0,2%, et enfin pour une énergie surfacique de collage hydrophile $E_s$ de 1J/m$^2$, la surface collée minimale $S_{bt}^{min}$ des bras tenseurs est d'environ $290\mu m^2$.

On effectue ensuite une étape de renforcement du collage moléculaire de la partie structurée 11 solidarisée de la surface libre 31 de la couche support, de manière à obtenir une valeur Es d'énergie surfacique de collage hydrophile supérieure ou égale à la valeur minimale $E_s^{min}$ déterminée préalablement. Pour cela, on réalise un traitement thermique, sous forme d'une sous-étape spécifique de recuit de consolidation, dans lequel on soumet l'empilement à une température de recuit Tr pendant quelques minutes à quelques heures. A titre illustratif, la température de recuit peut être de 200°C appliquée pendant 2h, ce qui augmente ici l'énergie surfacique de collage hydrophile de 100mJ/m$^2$ à 1J/m$^2$.

En référence à la figure 5d, on retire, par gravure, une portion distale 51 des bras tenseurs 50 de manière à individualiser la partie structurée 11 vis-à-vis de la partie périphérique 12 de la couche de germination 10. Cette étape est similaire à l'étape décrite précédemment en référence à la figure 1e et n'est pas détaillée davantage ici. Ainsi, on obtient une partie structurée 11 à portion contrainte de germination 40 collée par adhérence moléculaire hydrophile sur la couche support 30, dont la tenue mécanique est assurée. Le procédé selon le second mode de réalisation se distingue donc du premier mode de réalisation notamment par le collage hydrophile, dont l'intensité est supérieure à celle du collage hydrophobe jusqu'à des températures de recuit de l'ordre de 500°C à 600°C, et par la présence d'une couche 14, 15 d'un oxyde ou nitrure intercalaire à l'interface entre la partie structurée 11 et la couche support 30, dont la propriété diélectrique assure une isolation électrique entre ces éléments. Ce matériau intercalaire, outre une fonction d'isolation électrique, peut également assurer une fonction d'évacuation de la chaleur éventuellement produite au niveau de la portion contrainte, dans le cas où cette dernière forme une couche émissive d'une source lumineuse.

En référence à la figure 5e, on forme une portion semiconductrice 60 par croissance épitaxiale sur la portion contrainte de germination 40. Pour cela, on dépose tout d'abord sur la partie structurée 11 un masque de croissance 61 de sorte qu'une surface de germination 62 de la portion contrainte de germination 40 soit exposée. L'épitaxie est ensuite effectuée de sorte que la portion semiconductrice 60 croisse à partir de la surface de germination 62. Cette étape est similaire à celle décrite précédemment en référence à la figure 1e et n'est pas détaillée davantage.

On obtient ainsi une structure semiconductrice 1 comportant une portion épitaxiée 60 sur une portion contrainte de germination 40 d'une partie structurée 11 collée par adhérence moléculaire hydrophile à la couche support 30. La présence du matériau intercalaire diélectrique 14, 15 à l'interface entre la portion épitaxiée et la couche support permet notamment d'assurer une isolation électrique de la portion épitaxiée.

On décrit maintenant différents dispositifs optoélectroniques comportant une portion semiconductrice, épitaxiée sur la portion contrainte de germination, obtenue par le procédé selon l'invention décrit précédemment. A titre illustratif, les dispositifs optoélectroniques décrits par la suite comportent une portion semiconductrice en germanium-étain monocristallin épitaxiée de manière relaxée sur une portion contrainte de germination en germanium monocristallin collée sur une couche support en silicium. Bien entendu, les matériaux mentionnés ici ne le sont qu'à titre purement illustratif et d'autres matériaux adaptés peuvent être utilisés.

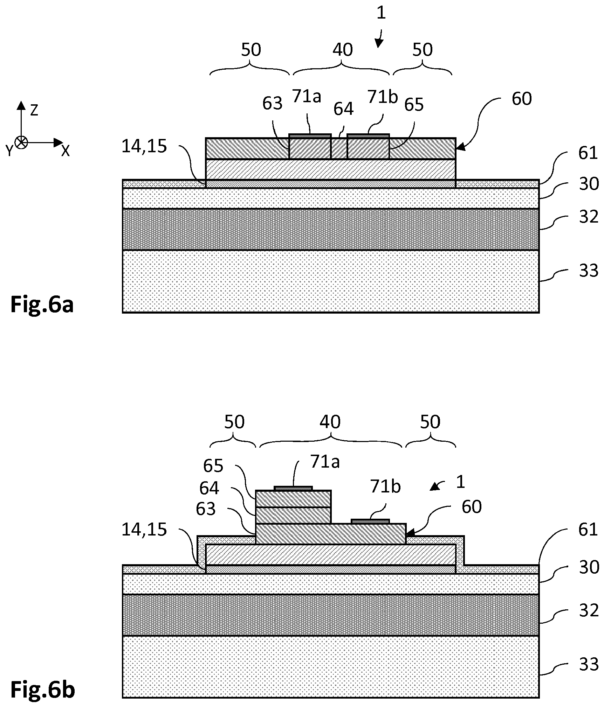

Les figures 6a et 6b représentent de manière schématique une vue en coupe de deux exemples d'un dispositif optoélectronique à émission de lumière non cohérente tel qu'une diode électroluminescente.

Sur la figure 6a, la diode électroluminescente comporte ici une structure semiconductrice 1 obtenue par le procédé de réalisation selon le second mode de réalisation, c'est-à-dire faisant intervenir un collage moléculaire hydrophile.

La structure semiconductrice 1 comporte une portion semiconductrice 60 en germanium-étain épitaxiée, ici en accord de maille, sur une portion contrainte de germination 40 mise en tension par des bras tenseurs 50. Elle est solidarisée à la couche support 30 par collage moléculaire hydrophile, ce qui se traduit par la présence d'un matériau intercalaire 14,15 ici un oxyde de silicium, situé à l'interface entre le germanium de la partie structurée 11 et le silicium de la couche support 30. La couche support 30 est ici une couche supérieure en silicium d'un substrat de type SOI. Elle repose sur une couche d'oxyde 32 située entre la couche support 30 et une couche inférieure 33 épaisse de silicium.

La portion semiconductrice 60 épitaxiée comporte une jonction PIN réalisée par implantation de dopants (phosphore et bore, dans le cas du germanium-étain) de manière à former une zone 63 dopée N voisine d'une zone 65 dopée P. Ici, une zone 64 intrinsèque (non intentionnellement dopée) sépare les zones 63, 65 dopées N et P. La jonction PIN s'étend de manière sensiblement verticale au-travers de la portion semiconductrice, en direction de la portion contrainte 40. Par ailleurs, deux plots 71a, 71b d'un matériau électriquement conducteur sont présents au niveau des zones dopées 63, 65, formant des contacts électriques. La structure semiconductrice 1 peut comporter une couche d'encapsulation (non représentée) qui recouvre la portion contrainte 40 et les bras tenseurs 50, ainsi que la portion épitaxiée 60.

Dans cet exemple, la portion semiconductrice 60 a été épitaxiée sur la portion contrainte de germination 40 mais également sur la surface des bras tenseurs 50. Dans la mesure où les bras tenseurs 50 ne présentent pas la même déformation moyenne que celle de la portion contrainte 40, la structure cristallographique de la portion épitaxiée 60 n'est alors pas homogène, selon que l'on considère la zone centrale située en regard de la portion contrainte 40 ou les zones latérales situées en regard des bras tenseurs 50. Il est alors avantageux que la jonction PIN et les contacts électriques soient situés au niveau de la zone centrale de la portion épitaxiée 60, permettant ainsi de limiter les pertes lors de l'injection électrique.

A titre d'exemple, la portion semiconductrice de germanium-étain de la diode présente une épaisseur moyenne de 300nm. La portion contrainte également une épaisseur moyenne de 300nm. Elle présente une surface collée de l'ordre de quelques microns carrés, par exemple $1\mu m^2$, et une déformation moyenne biaxiale de 2% environ. Les bras tenseurs présentent une surface minimale collée de l'ordre de $305\mu m^2$. La structure semiconductrice est solidarisée par collage moléculaire hydrophile d'une valeur minimale de $1J/m^2$ obtenue à la suite d'un recuit de consolidation à une température de 200°C environ pendant une durée suffisante de quelques minutes à quelques heures.

La diode électroluminescente peut être obtenue de la manière suivante. On réalise tout d'abord la structure semiconductrice 1 par le procédé selon le second mode de réalisation, puis on réalise les zones dopées 63, 65 par implantation d'impuretés, par exemple du phosphore et du bore dans le cas du germanium-étain. Les contacts électriques 71a, 71b sont ensuite réalisés. Une couche d'encapsulation est ensuite déposée puis aplanie par une technique de polissage mécano-chimique de type CMP (pour *Chemical Mechanical Polishing,* en anglais) puis localement gravée de manière à rendre accessibles les contacts électriques.

La figure 6b illustre une variante de la diode électroluminescente illustrée sur la figure 6a, qui s'en distingue essentiellement en ce qu'une jonction PIN s'étend de manière sensiblement parallèle au plan de la couche support.

La portion semiconductrice épitaxiée 60 est structurée dans son épaisseur, de manière à présenter une partie inférieure 63 dopée selon un premier type de conductivité, ici de type P, reposant sur la portion de germination 40 collée à la couche support 30. Sur la partie inférieure dopée P repose une partie supérieure 65 dopée selon un second type de conductivité, ici de type N. Une partie intrinsèque 64 est située entre la partie supérieure 65 dopée N et la partie inférieure 63 dopée P, et présente ici des dimensions dans le plan (X,Y) sensiblement identiques à celles de la partie supérieure 65. Ainsi, les parties dopées P et N et la partie intrinsèque forment ensemble une jonction PIN qui s'étend suivant un plan sensiblement parallèle au plan (X,Y). Deux plots 71a, 71b d'un matériau électriquement conducteur, formant des contacts électriques, sont disposés sur la partie supérieure 65 dopée N et sur une zone libre de la partie inférieure 63 dopée P.

A titre d'exemple, la partie inférieure 63 de la portion épitaxiée présente une épaisseur de l'ordre de 200nm, et un niveau de dopage de l'ordre de $2.10^{19}$ cm$^{-3}$. La partie intrinsèque 64 présente une épaisseur ici de l'ordre de 100nm et la partie supérieure 65 une épaisseur de l'ordre de 200nm et un niveau de dopage de l'ordre de $2.10^{19}$ cm$^{-3}$. La partie inférieure 63 de la portion épitaxiée présente une surface collée de l'ordre de quelques microns carrés, par exemple $1\mu m^2$, et la portion contrainte 40 présente une déformation moyenne biaxiale de 2% environ. Les bras tenseurs 50 présentent une surface collée de l'ordre de $300\mu m^2$. La structure semiconductrice 1 est solidarisée par collage moléculaire hydrophile d'une valeur minimale de $1J/m^2$ obtenue à la suite d'un recuit de consolidation à une température de 200°C environ pendant une durée suffisante de quelques minutes à quelques heures.

Les parties dopées de la portion épitaxiée peuvent avoir été réalisées lors de la croissance épitaxiale de la portion semiconductrice de germanium-étain. De manière alternative, elles peuvent être obtenues après réalisation de la structure semiconductrice, par des étapes d'implantation des impuretés dopantes à différentes profondeurs.

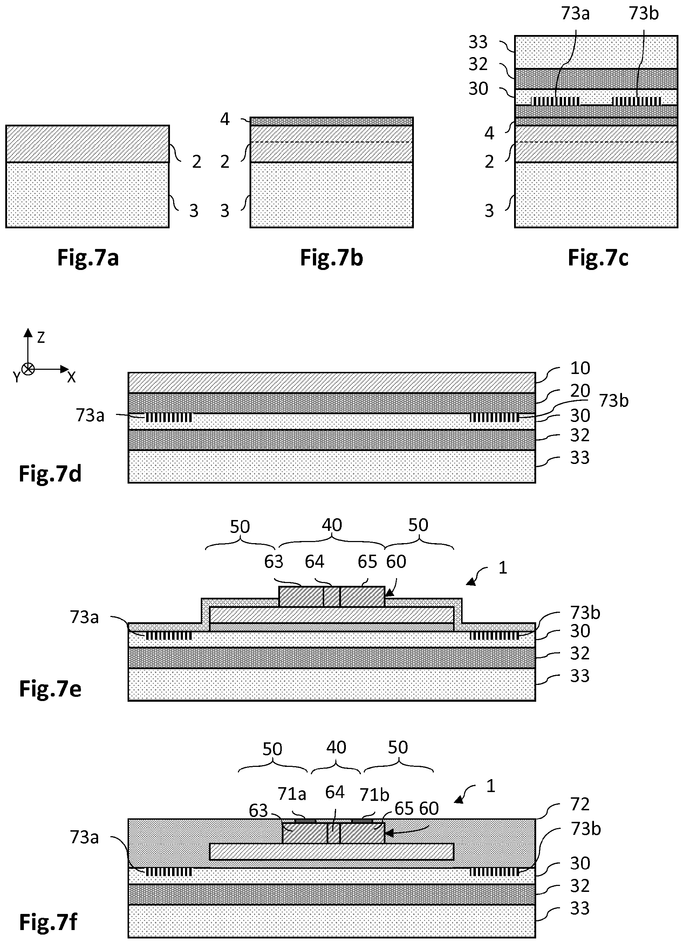

Les figures 7a à 7f représentent de manière schématique en vue en coupe différentes étapes d'un exemple de procédé de réalisation d'une source laser dans laquelle la cavité optique est réalisée au niveau de la couche support.

Dans cet exemple, on réalise, par exemple par épitaxie RP-CVD (pour *Reduced Pressure Chemical Vapor Deposition,* en anglais), une couche 2 d'un matériau semiconducteur, ici du germanium, sur un substrat 3 de silicium (figure 7a). On recouvre ensuite la couche de germanium d'une couche d'oxyde 4 puis on implante des ions H+ dans la couche de germanium (trait pointillé sur la figure 7b). On réalise ensuite une couche en silicium destinée à former la couche support 30, ici sous forme d'un substrat SOI, dans laquelle on réalise au niveau de sa surface 31, deux miroirs de Bragg 73a, 73b (ou des éléments optiques équivalents) destinés à former une cavité optique. La surface 31 de la couche support est ensuite recouverte d'une couche d'oxyde. On solidarise le substrat SOI ainsi obtenu avec la surface de la couche d'oxyde 4 (figure 7c). On effectue la rupture de la couche de germanium 2 au niveau de la zone d'implantation d'ions et on obtient ainsi un empilement d'une couche de germination 10 de germanium solidaire d'une couche support 30 en silicium par l'intermédiaire d'une couche sacrificielle 20 en oxyde de silicium. Les deux miroirs de Bragg 73a, 73b sont enterrés dans la couche support 30 au niveau de l'interface avec la couche sacrificielle 20 (figure 7d). On obtient ensuite une structure semiconductrice 1 par croissance épitaxiale, ici en accord de maille, d'une portion semiconductrice sur une partie structurée 11 individualisée issue de la couche de germination 10 à partir du procédé selon le second mode de réalisation. Les miroirs de Bragg sont situés ici de part et d'autre de la portion semiconductrice et forment une cavité optique au niveau de laquelle la portion est placée (figure 7e). Les miroirs de Bragg 73a, 73b peuvent ainsi être disposés en regard ou non des bras tenseurs 50. Alternativement, la cavité optique peut être formée par un unique réseau de Bragg situé en regard de la portion semiconductrice tout en comportant un défaut de périodicité du réseau formant une cavité en $\lambda/4$, $\lambda$ étant la longueur d'onde du faisceau lumineux destiné à être émis par la source de lumière. On réalise ensuite une jonction PIN dans la portion semiconductrice, la jonction comportant une partie dopée N et une partie dopée P, ici séparées l'une de l'autre par une partie intrinsèque (non intentionnellement dopée). La jonction PIN s'étend ici suivant l'épaisseur de la portion semiconductrice (figure 7e). On réalise enfin des contacts électriques 71a, 71b respectivement sur la partie dopée 63 et la partie dopée 65 et on dépose une couche d'encapsulation 72, par exemple en oxyde de silicium, qui recouvre la structure semiconductrice 1 tout en laissant accessible les contacts électriques 71a, 71b (figure 7f). Par ailleurs, la couche support peut avoir été préalablement structurée de manière à former le coeur d'un guide d'onde entourée d'une gaine formée par l'oxyde de silicium, le coeur s'étend sensiblement en regard de la portion contrainte et de la portion semiconductrice épitaxiée.

Des modes de réalisation particuliers viennent d'être décrits. Différentes variantes et modifications apparaîtront à l'homme du métier.

Ainsi, les dispositifs optoélectroniques décrits précédemment le sont à titre uniquement illustratif. D'autres dispositifs optoélectroniques peuvent être réalisés, par exemple des sources laser à pompage optique ou électrique, avec ou non jonction PN, PIN, des diodes électroluminescentes, voire des photodétecteurs.

Par ailleurs, comme mentionné précédemment, l'étape d'individualisation de la partie structurée 11 vis-à-vis de la partie périphérique 12 peut être effectuée avant ou après l'étape de croissance épitaxiale de la portion semiconductrice 60 sur la portion contrainte de germination 40.

Enfin, de manière avantageuse, une pluralité de structures semiconductrices 1 peuvent être réalisées de manière simultanée par épitaxie de portions semiconductrices 60 distinctes sur des portions contraintes de germination 40 formées à partir de la même couche de germination 10. Les structures semiconductrices sont alors adjacentes et séparées les unes des autres. Ainsi, chaque structure semiconductrice est distincte de ses voisines, c'est-à-dire non rattachée à la partie périphérique correspondante de la même couche de germination.

## Revendications

1. Procédé de formation d'une portion semiconductrice (60) par croissance épitaxiale sur une portion contrainte de germination (40), comportant les étapes dans lesquelles :

   i) on fournit un empilement formé d'une couche de germination (10) recouvrant une couche sacrificielle (20) disposée sur une couche support (30), ladite couche de germination (10) présentant une valeur initiale non nulle de contrainte en tension ;
   ii) on structure la couche de germination (10) de manière à former une partie structurée (11) et une partie périphérique (12), la partie structurée (11) comportant une portion centrale (40) reliée à la partie périphérique (12) par au moins deux portions latérales (50) opposées l'une à l'autre vis-à-vis de la portion centrale (40), les portions latérales (50) présentant une largeur moyenne supérieure à une largeur moyenne de la portion centrale (40) ;
   iii) on réalise une cavité (21) sous la partie structurée (11) en rendant libre une surface (31) de la couche support (30) située en regard de la partie structurée (11), la portion centrale (40), dite portion contrainte de germination, étant alors contrainte en tension à une valeur finale supérieure à la valeur initiale ;
   iv) on forme la portion semiconductrice (60) par croissance épitaxiale sur la portion contrainte de germination (40) ;

   dans lequel, lors de l'étape iii), on réalise en outre une mise en contact de la partie structurée (11) avec ladite surface libre (31) de manière à rendre solidaire la partie structurée (11) de ladite surface libre (31).

2. Procédé selon la revendication 1, comportant en outre les étapes suivantes :
   - préalablement à l'étape i) de fourniture, estimation d'une valeur finale $\left(\sigma_{pc}^{f}\right)$ de contrainte en tension pour laquelle la couche de germination (10) présente un paramètre de maille finale $\left(a_{pc}^{f}\right)$ sensiblement égal au paramètre de maille dit naturel $(a_{ps})$ de la portion semiconductrice (60) ;
   - détermination de la structuration de sorte que, après l'étape iii) de réalisation de la cavité (21), la portion contrainte de germination (40) présente ladite valeur finale $\left(\sigma_{pc}^{f}\right)$ de contrainte en tension, et donc un paramètre de maille $\left(a_{pc}^{f}\right)$ sensiblement égal au paramètre de maille naturel $(a_{ps})$ de la portion semiconductrice (60), de sorte que, lors de l'étape iv), la portion semiconductrice (60) est épitaxiée de manière sensiblement relaxée.

3. Procédé selon la revendication 2, dans lequel, lors de l'étape de détermination, la largeur moyenne des portions latérales (50) et la largeur moyenne de la portion centrale (40) sont choisies de sorte que la portion centrale (40) présente, lors de l'étape de réalisation de la cavité (21), ladite valeur finale $\left(\sigma_{pc}^{f}\right)$ de contrainte en tension.

4. Procédé selon l'une quelconque des revendications 1 à 3, dans lequel l'étape iv) comporte une sous-étape préalable dans laquelle on dépose un masque de croissance (61) sur la partie structurée (11) de manière à recouvrir les portions latérales (50) et à rendre libre une surface (62) de la portion centrale de germination (40), dite surface de germination, la portion semiconductrice (60) étant formée à partir de la surface de germination (62).

5. Procédé selon l'une quelconque des revendications 1 à 4, dans lequel, à la suite de l'étape iii), la partie structurée (11) est solidaire de la surface libre (31) de la couche support (30) par collage moléculaire, et dans lequel on effectue les sous-étapes suivantes :

   a) on détermine une valeur minimale d'énergie de collage moléculaire de la partie structurée (11) sur la couche support (30), ainsi qu'une valeur minimale de surface collée des portions latérales (50) sur la couche support (30), ces valeurs minimales étant telles que ladite énergie de collage moléculaire est supérieure à une énergie élastique de la partie structurée (11) ;

b) on effectue, après l'étape iii) ou iv), un recuit de consolidation à une température de recuit telle que l'énergie de collage moléculaire présente une valeur supérieure ou égale à ladite valeur minimale préalablement déterminée ; puis

c) on grave une partie distale (51) des portions latérales (50) vis-à-vis de la portion contrainte de germination (40), de sorte que la surface collée des portions latérales (50) présente une valeur supérieure ou égale à ladite valeur minimale préalablement déterminée.

6. Procédé selon la revendication 5, dans lequel on réalise l'étape c) de gravure après l'étape iv) de croissance épitaxiale au cours de laquelle on effectue l'étape b) de recuit de consolidation.

7. Procédé selon la revendication 5 ou 6, dans lequel, lors de l'étape c), on grave une partie distale (51) des portions latérales (50) formant raccord avec la partie périphérique (12) de la couche de germination (10).

8. Procédé selon la revendication 7, dans lequel, à la suite de l'étape c), la partie structurée (11) présente une face supérieure opposée à la couche support (30) sensiblement plane.

9. Procédé selon l'une quelconque des revendications 5 à 8, dans lequel, lors de l'étape iii), on réalise la cavité (21) et la mise en contact par gravure par HF en phase vapeur éventuellement suivie par le dépôt puis l'évaporation d'un liquide au niveau de la cavité, et dans lequel, lors de l'étape b) la température de recuit est supérieure ou égale à 200°C.

10. Procédé selon l'une quelconque des revendications 5 à 8, dans lequel, lors de l'étape iii), on réalise une oxydation ou une nitruration de ladite surface libre (31) et d'une surface de la partie structurée (11) orientée vers la surface libre, et dans lequel, lors de l'étape b) la température de recuit est supérieure ou égale à 100°C.

11. Procédé selon la revendication 10, dans lequel, à la suite de l'étape iii), une couche diélectrique (14, 15), issue de ladite oxydation ou nitruration réalisée, est formée à l'interface entre la partie structurée (11) et la couche support (30), qui présente une épaisseur supérieure ou égale à 10nm.

12. Procédé selon l'une quelconque des revendications précédentes, dans lequel, lors de l'étape ii), la structuration des portions latérales (50) est réalisée de sorte que, lors de l'étape iii), la portion contrainte de germination (40) présente une déformation uniaxiale ou biaxiale.

13. Procédé selon l'une quelconque des revendications précédentes, dans lequel la portion semiconductrice épitaxiée (60) comporte au moins une partie dopée (63, 65) avec un niveau de dopage supérieur ou égal à $2.10^{18}$ cm$^{-3}$.

14. Procédé de réalisation d'un dispositif optoélectronique comportant une portion semiconductrice (60) obtenue par le procédé selon l'une quelconque des revendications 1 à 13, dans lequel on réalise une jonction PN ou PIN (63, 64, 65) dans la portion semiconductrice, la jonction s'étendant de manière sensiblement orthogonale ou parallèle au plan de la couche support (30).

15. Procédé de réalisation d'un dispositif optoélectronique comportant une portion semiconductrice obtenue par le procédé selon l'une quelconque des revendications 1 à 13, dans lequel on réalise une cavité optique dans laquelle est située la portion semiconductrice (60) dont le matériau est adapté à former un milieu à gain, le dispositif obtenue étant adapté à émettre un faisceau lumineux cohérent.

**Patentansprüche**

1. Verfahren zur Erstellung eines Halbleiterabschnitts (60) durch epitaxisches Wachstum auf einem gespannten Keimabschnitt (40), das die folgenden Schritte aufweist:

i) Bereitstellen eines Stapels, der aus einer Keimschicht (10) gebildet ist, die eine Opferschicht (20) bedeckt, die auf einer Trägerschicht (30) angeordnet wird, wobei die Keimschicht (10) einen Anfangswert der Zugspannung, der nicht gleich Null ist, aufweist;

ii) Strukturieren der Keimschicht (10) derart, um einen strukturierten Teil (11) und einen peripheren Teil (12) zu bilden, wobei der strukturierte Teil (11) einen Mittelabschnitt (40) aufweist, der mit dem peripheren Teil (12) durch mindestens zwei Seitenabschnitte (50) verbunden wird, die gegenüber dem Mittelabschnitt (40) einander gegenüberliegen, wobei die Seitenabschnitte (50) eine mittlere Breite aufweisen, die größer als eine mittlere Breite des Mittelabschnitts (40) ist;

iii) Erstellen eines Hohlraums (21) unter dem strukturierten Teil (11), indem eine Oberfläche (31) der Trägerschicht (30), die dem strukturierten Teil (11) zugewandt angeordnet wird, freigemacht wird, wobei der Mittelabschnitt (40), der gespannter Keimabschnitt genannt wird, dann auf einen Endwert, der größer als der Anfangswert ist, gespannt wird;

iv) Erstellen des Halbleiterabschnitts (60) durch epitaxisches Wachstum auf dem gespannten Keimabschnitt (40);

wobei in Schritt iii) ferner ein Inkontaktbringen des strukturierten Teils (11) mit der freien Oberfläche (31) derart durchgeführt wird, dass der strukturierte Teil (11) mit der freien Oberfläche (31) fest verbunden wird.

2. Verfahren nach Anspruch 1, ferner umfassend die folgenden Schritte:

- vor dem Schritt i) des Bereitstellens Schätzen eines Endwerts $(\sigma_{pc}^{f})$ der Zugspannung, für den die Keimschicht (10) einen endgültigen Gitterparameter $(a_{pc}^{f})$ aufweist, der im Wesentlichen gleich dem natürlichen Gitterparameter $(a_{ps})$ des Halbleiterabschnitts (60) ist;

- Bestimmen der Strukturierung derart, dass der gespannte Keimabschnitt (40) nach dem Schritt iii) des Erstellens des Hohlraums (21) den Endwert $(\sigma_{pc}^{f})$ der Zugspannung und somit einen Gitterparameter $(a_{pc}^{f})$ aufweist, der im Wesentlichen gleich dem natürlichen Gitterparameter $(a_{ps})$ des Halbleiterabschnitts (60) ist, sodass der Halbleiterabschnitt (60) bei dem Schritt iv) im Wesentlichen entspannt epitaxisch ist.

3. Verfahren nach Anspruch 2, **dadurch gekennzeichnet, dass** beim Schritt des Bestimmens die mittlere Breite der Seitenabschnitte (50) und die mittlere Breite des Mittelabschnitts (40) derart ausgewählt werden, dass der Mittelabschnitt (40) beim Schritt des Erstellens des Hohlraums (21) den Endwert $(\sigma_{pc}^{f})$ der Zugspannung aufweist.

4. Verfahren nach einem der Ansprüche 1 bis 3, wobei der Schritt iv) einen vorhergehenden Unterschritt aufweist, bei dem eine Wachstumsmaske (61) auf den strukturierten Teil (11) derart aufgetragen wird, um die Seitenabschnitte (50) zu bedecken und die Oberfläche (62) des mittleren Keimabschnitts (40), die Keimoberfläche genannt wird, frei zu machen, wobei der Halbleiterabschnitt (60) aus der Keimoberfläche (62) gebildet wird.

5. Verfahren nach einem der Ansprüche 1 bis 4, wobei der strukturierte Teil (11) nach dem Schritt iii) mit der freien Oberfläche (31) der Trägerschicht (30) durch Molekularkleben fest verbunden wird und wobei die folgenden Unterschritte durchgeführt werden:

a) Bestimmen eines minimalen Energiewerts des Molekularklebens des strukturierten Teils (11) auf die Trägerschicht (30) und eines minimalen Wertes der geklebten Oberfläche der Seitenabschnitte (50) auf der Trägerschicht (30), wobei diese minimalen Werte derart sind, dass die Energie des Molekularklebens größer als eine elastische Energie des strukturierten Teils (11) ist;

b) nach dem Schritt iii) oder iv) Durchführen eines Verfestigungsglühens bei einer derartigen Glühtemperatur, dass die Energie des Molekularklebens einen Wert aufweist, der größer gleich dem zuvor bestimmten minimalen Wert ist, und dann

c) Ätzen eines distalen Teils (51) der Seitenabschnitte (50) gegenüber von dem gespannten Keimabschnitt (40) derart, dass die geklebte Oberfläche der Seitenabschnitte (50) einen Wert aufweist, der größer gleich dem zuvor bestimmten minimalen Wert ist.

6. Verfahren nach Anspruch 5, wobei der Schritt c) des Ätzens nach dem Schritt iv) des epitaxischen Wachstums durchgeführt wird, bei dem der Schritt b) des Verfestigungsglühens durchgeführt wird.

7. Verfahren nach Anspruch 5 oder 6, wobei bei dem Schritt c) ein distaler Teil (51) der Seitenabschnitte (50) geätzt wird, der eine Verbindung mit dem peripheren Teil (12) der Keimschicht (10) bildet.

8. Verfahren nach Anspruch 7, wobei der strukturierte Teil (11) nach dem Schritt c) eine obere Fläche aufweist, die der Trägerschicht (30) gegenüberliegt, die im Wesentlichen eben ist.

**9.** Verfahren nach einem der Ansprüche 5 bis 8, wobei bei dem Schritt iii) der Hohlraum (21) erstellt und das Inkontaktbringen durch HF-Ätzung in der Dampfphase durchgeführt wird, auf das eventuell das Abscheiden und dann das Verdampfen einer Flüssigkeit auf Ebene des Hohlraums folgt, und wobei bei dem Schritt b) die Glühtemperatur mehr als oder gleich 200 °C beträgt.

**10.** Verfahren nach einem der Ansprüche 5 bis 8, wobei bei dem Schritt iii) ein Oxidieren oder Nitrieren der freien Oberfläche (31) und einer Oberfläche des strukturierten Teils (11), der zu der freien Oberfläche gerichtet ist, durchgeführt wird, und wobei bei dem Schritt b) die Glühtemperatur mehr als oder gleich 100°C beträgt.

**11.** Verfahren nach Anspruch 10, wobei nach dem Schritt iii) eine dielektrische Schicht (14, 15), die aus dem durchgeführten Oxidieren oder Nitrieren hervorgegangen ist, an der Schnittstelle zwischen dem strukturierten Teil (11) und der Trägerschicht (30) gebildet wird, die eine Dicke aufweist, die größer gleich 10nm ist.

**12.** Verfahren nach einem der vorhergehenden Ansprüche, **dadurch gekennzeichnet, dass** bei dem Schritt ii) das Strukturieren der Seitenabschnitte (50) derart durchgeführt wird, dass der gespannte Keimabschnitt (40) bei dem Schritt iii) eine uniaxiale oder biaxiale Verformung aufweist.

**13.** Verfahren nach einem der vorhergehenden Ansprüche, wobei der epitaxische Halbleiterabschnitt (60) mindestens einen dotierten Teil (63, 65) mit einem Dotierungsniveau von größer gleich $2.10^{18}$ cm$^{-3}$ aufweist.

**14.** Verfahren zur Erstellung einer optoelektronischen Vorrichtung, umfassend einen Halbleiterabschnitt (60), der nach dem Verfahren nach einem der Ansprüche 1 bis 13 erhalten wird, wobei ein pn- oder pin-Übergang (63, 64, 65) in einem Halbleiterabschnitt erstellt wird, wobei sich der Übergang im Wesentlichen orthogonal oder parallel zu der Ebene der Trägerschicht (30) erstreckt.

**15.** Verfahren zur Erstellung einer optoelektronischen Vorrichtung, umfassend einen Halbleiterabschnitt, der nach dem Verfahren nach einem der Ansprüche 1 bis 13 erhalten wird, wobei ein optischer Hohlraum erstellt wird, in dem der Halbleiterabschnitt (60) angeordnet wird, dessen Material geeignet ist, ein Verstärkungsmedium zu bilden, wobei die erhaltene Vorrichtung geeignet ist, einen kohärenten Lichtstrahl auszusenden.

**Claims**

**1.** Method for forming a semiconducting portion (60) by epitaxial growth on a strained germination portion (40), comprising the steps in which:

> i) a stack is provided, formed of a germination layer (10) covering a sacrificial layer (20) disposed on a support layer (30), said germination layer (10) exhibiting a non-zero initial value of tensile strain;
> ii) the germination layer (10) is structured in such a way as to form a structured part (11) and a peripheral part (12), the structured part (11) comprising a central portion (40) linked to the peripheral part (12) by at least two lateral portions (50) opposite one another in relation to the central portion (40), the lateral portions (50) exhibiting a greater average width than an average width of the central portion (40);
> iii) a cavity (21) is produced under the structured part (11) while rendering free a surface (31) of the support layer (30) situated facing the structured part (11), the central portion (40), termed the strained germination portion, then being strained under tension to a final value greater than the initial value;
> iv) the semiconducting portion (60) is formed by epitaxial growth on the strained germination portion (40);

in which, during step iii), the structured part (11) is furthermore placed in contact with said free surface (31) in such a way as to bind the structured part (11) of said free surface (31).

**2.** Method according to Claim 1, furthermore comprising the following steps:

> - prior to step i) of provision, estimation of a final value $\left(\sigma_{pc}^{f}\right)$ of tensile strain for which the germination layer (10) exhibits a final cell parameter $\left(a_{pc}^{f}\right)$ substantially equal to the so-called natural cell parameter $(a_{ps})$ of the semiconducting portion (60);
>
> - determination of the structuring so that, after step iii) of producing the cavity (21), the strained germination portion (40) exhibits said final value $\left(\sigma_{pc}^{f}\right)$ of tensile strain, and therefore a cell parameter $\left(a_{pc}^{f}\right)$ substantially equal to the natural cell parameter ($a_{ps}$) of the semiconducting portion (60), so that, during step iv), the semiconducting portion (60) is epitaxied in a substantially relaxed manner.

3. Method according to Claim 2, in which, during the determination step, the average width of the lateral portions (50) and the average width of the central portion (40) are chosen so that the central portion (40) exhibits, during the step of producing the cavity (21), said final value $\left(\sigma_{pc}^{f}\right)$ of tensile strain.

4. Method according to any one of Claims 1 to 3, in which step iv) comprises a prior sub-step in which a growth mask (61) is deposited on the structured part (11) so as to cover the lateral portions (50) and to render free a surface (62) of the central germination portion (40), termed the germination surface, the semiconducting portion (60) being formed on the basis of the germination surface (62).

5. Method according to any one of Claims 1 to 4, in which, subsequent to step iii), the structured part (11) is tied to the free surface (31) of the support layer (30) by molecular bonding, and in which the following sub-steps are performed:

   a) a minimum value of molecular bonding energy of the structured part (11) on the support layer (30) is determined, together with a minimum value of bonded area of the lateral portions (50) on the support layer (30), these minimum values being such that said molecular bonding energy is greater than an elastic energy of the structured part (11);
   b) after step iii) or iv), a consolidation annealing is performed at an annealing temperature such that the molecular bonding energy exhibits a value greater than or equal to said previously determined minimum value; and then
   c) a distal part (51) of the lateral portions (50) in relation to the strained germination portion (40) is etched, so that the bonded area of the lateral portions (50) exhibits a value greater than or equal to said previously determined minimum value.

6. Method according to Claim 5, in which step c) of etching is carried out after step iv) of epitaxial growth in the course of which the consolidation annealing step b) is performed.

7. Method according to Claim 5 or 6, in which, during step c), a distal part (51) of the lateral portions (50) joining with the peripheral part (12) of the germination layer (10) is etched.

8. Method according to Claim 7, in which, subsequent to step c), the structured part (11) exhibits an upper face opposite to the substantially plane support layer (30).

9. Method according to any one of Claims 5 to 8, in which, during step iii), the cavity (21) is produced and contacting by HF vapor-phase etching is carried out optionally followed by the deposition and then the evaporation of a liquid at the level of the cavity, and in which, during step b) the annealing temperature is greater than or equal to 200°C.

10. Method according to any one of Claims 5 to 8, in which, during step iii), an oxidation or a nitriding of said free surface (31) and of a surface of the structured part (11) oriented toward the free surface is carried out, and in which, during step b) the annealing temperature is greater than or equal to 100°C.

11. Method according to Claim 10, in which, subsequent to step iii), a dielectric layer (14, 15), arising from said oxidation or nitriding carried out, is formed at the interface between the structured part (11) and the support layer (30), which exhibits a thickness of greater than or equal to 10nm.

12. Method according to any one of the preceding claims, in which, during step ii), the structuring of the lateral portions (50) is carried out so that, during step iii), the strained germination portion (40) exhibits a uniaxial or biaxial deformation.

13. Method according to any one of the preceding claims, in which the epitaxied semiconducting portion (60) comprises at least one doped part (63, 65) with a doping level of greater than or equal to $2.10^{18}$ $cm^{-3}$.

14. Method for producing an optoelectronic device comprising a semiconducting portion (60) obtained by the method according to any one of Claims 1 to 13, in which a PN or PIN junction (63, 64, 65) is produced in the semiconducting portion, the junction extending in a manner substantially orthogonal or parallel to the plane of the support layer (30).

15. Method for producing an optoelectronic device comprising a semiconducting portion obtained by the method according to any one of Claims 1 to 13, in which an optical cavity is produced in which is situated the semiconducting portion (60) whose material is suitable for forming a gain medium, the device obtained being suitable for emitting a coherent light beam.

**Fig.1a**

**Fig.1b**

**Fig.1c**

**Fig.1d**

**Fig.1e**

**Fig.2a**

**Fig.2b**

**Fig.3a**

**Fig.3b**

**Fig.4**

Fig.5a

Fig.5b

Fig.5c

Fig.5d

Fig.5e

**Fig.6a**

**Fig.6b**

Fig.7a

Fig.7b

Fig.7c

Fig.7d

Fig.7e

Fig.7f

$$\{\sigma_{pc}^{f} > 0\} / a_{pc}^{f} \cong a_{ps}$$

$$\{\sigma_{pc}^{f} > \sigma_{pc}^{i} > 0 \; ; \; a_{pc}^{i} < a_{ps}$$

$$F / \{\sigma_{pc}^{f} = F(\sigma_{pc}^{i})$$

$$\{\sigma_{pc}^{i} \rightarrow \{\sigma_{pc}^{f} = F(\sigma_{pc}^{i}) / a_{pc}^{f} \cong a_{ps}$$

**Fig.8**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 03045837 A

**Littérature non-brevet citée dans la description**

- High-quality fully relaxed In0.65Ga0.35As layers grown on InP using the paramorphic approach. **DAMLENCOURT J F et al.** APPLIED PHYSICS LETTERS. AMERICAN INSTITUTE OF PHYSICS, 06 Décembre 1999, vol. 75, 3638-3640
- Growth and characterization of totally relaxed InGaAs thick layers on strain-relaxed paramorphic InP substrates. **BOUDAA M et al.** JOURNAL OF ELECTRONIC MATERIALS TMS. IEEE, Juillet 2004, vol. 33, 833-839
- Dislocation-free strained silicon-on-silicon by in-place bonding. **COHEN G et al.** APPLIED PHYSICS LETTERS. AMERICAN INSTITUTE OF PHYSICS, 13 Juin 2005, vol. 86, 251902-1-251902-3

- **REBOUD et al.** Structural and optical properties of 200 mm germanium-on-insulator (GeOI) substrates for silicon photonics applications. *Proc. SPIE 9367, Silicon Photonics,* 27 Février 2015, vol. X, 936714
- **JAN et al.** Tensile-strained germanium-on-insulator substrate for silicon-compatible optoelectronics. *Opt. Mater. Express,* 2011, vol. 1, 1121-1126
- **SÜESS et al.** Analysis of enhanced light emission from highly strained germanium microbridges. *Nature Photon.,* 2013, vol. 7, 466-472